# EUROPEAN PATENT APPLICATION

(11) **EP 4 456 693 A1**
(43) Date of publication of application: **30.10.2024**
(21) Application number: 23219794.7
(22) Date of filing: 22.12.2023
(51) Int. Cl.: H10B 61/00, H10N 50/01

(54) **SEMICONDUCTOR DEVICE**

(30) Priority: 27.04.2023 KR 20230055413
(71) Applicant: Samsung Electronics Co., Ltd., Suwon-si, Gyeonggi-do 16677 (KR)
(72) Inventor: LEE, Jong-Hyuk, 16677 Suwon-si (KR); KO, Seung Pil, 16677 Suwon-si (KR)
(74) Representative: Marks & Clerk LLP

(57) **Abstract**

A semiconductor device may include a substrate including a cell region and a peripheral region, a bottom electrode overlapping the cell region, a magnetic tunnel junction pattern on the bottom electrode, a top electrode on the magnetic tunnel junction pattern, a buffer insulating layer overlapping the peripheral region, a capping insulating layer in contact with a side surface of the top electrode and a top surface of the buffer insulating layer, and a first peripheral conductive structure penetrating the capping insulating layer and the buffer insulating layer. A level difference between the top surface of the buffer insulating layer and a top surface of the top electrode may be smaller than a thickness of the capping insulating layer.

## Description

### BACKGROUND

The present disclosure relates to a semiconductor device, and in particular, to a semiconductor device including a buffer insulating layer.

As the demand for electronic devices with increased speed and/or reduced power consumption increases, the demand for semiconductor memory devices with faster operating speeds and/or lower operating voltages is increasing. A magnetic memory device has been proposed to satisfy such a demand. For example, the magnetic memory device can provide technical advantages, such as high speed and/or non-volatility, and thus, the magnetic memory device is emerging as a next-generation memory device.

In general, the magnetic memory device includes a magnetic tunnel junction (MTJ) pattern. The MTJ pattern includes two magnetic layers and an insulating layer interposed therebetween. Resistance of the MTJ pattern may vary depending on magnetization directions of the magnetic layers. For example, the resistance of the MTJ pattern may be higher when magnetization directions of the magnetic layers are anti-parallel to each other than when they are parallel to each other. Such a difference in resistance can be used for data storing/reading operations of the magnetic memory device.

An embedded structure of the magnetic memory device, in which the MTJ pattern is disposed between metal lines, is being developed to meet various demands for the electronics industry.

### SUMMARY

An embodiment of inventive concepts provides a semiconductor device with improved electrical and/or reliability characteristics.

According to an embodiment of inventive concepts, a semiconductor device may include a substrate including a cell region and a peripheral region, a bottom electrode overlapping the cell region, a magnetic tunnel junction pattern on the bottom electrode, a top electrode on the magnetic tunnel junction pattern, a buffer insulating layer overlapping the peripheral region, a capping insulating layer in contact with a side surface of the top electrode and a top surface of the buffer insulating layer, and a first peripheral conductive structure penetrating the capping insulating layer and the buffer insulating layer. A level difference between the top surface of the buffer insulating layer and a top surface of the top electrode may be smaller than a thickness of the capping insulating layer.

According to an embodiment of inventive concepts, a semiconductor device may include a substrate including a cell region and a peripheral region, a bottom electrode overlapping the cell region, a magnetic tunnel junction pattern on the bottom electrode, a top electrode on the magnetic tunnel junction pattern, a buffer insulating layer overlapping the peripheral region, a capping insulating layer in contact with a side surface of the top electrode and a top surface of the buffer insulating layer, a filling insulating layer on the capping insulating layer, and a first peripheral conductive structure penetrating the capping insulating layer and the buffer insulating layer. The filling insulating layer may include a filling insulating portion disposed between the buffer insulating layer and the top electrode. A dielectric constant of the buffer insulating layer may be smaller than a dielectric constant of the filling insulating layer.

According to an embodiment of inventive concepts, a semiconductor device may include a substrate including a cell region and a peripheral region, a cell conductive structure overlapping the cell region, a first peripheral conductive structure overlapping the peripheral region, a bottom electrode contact on the cell conductive structure, a bottom electrode on the bottom electrode contact, a magnetic tunnel junction pattern on the bottom electrode, a top electrode on the magnetic tunnel junction pattern, a second peripheral conductive structure on the first peripheral conductive structure, a molding insulating layer overlapping the peripheral region, an intervening insulating layer on the molding insulating layer, a buffer insulating layer on the intervening insulating layer, a capping insulating layer in contact with a side surface of the top electrode and a top surface of the buffer insulating layer, a filling insulating layer on the capping insulating layer, a protection insulating layer in contact with the capping insulating layer and the filling insulating layer, a third peripheral conductive structure penetrating the protection insulating layer, the capping insulating layer, and the buffer insulating layer and connected to the second peripheral conductive structure, and a cell conductive line on the top electrode. A dielectric constant of the buffer insulating layer and a dielectric constant of the molding insulating layer may be smaller than a dielectric constant of the filling insulating layer.

According to an embodiment of inventive concepts, a method of fabricating a semiconductor device may include providing a substrate including a cell region and a peripheral region; forming a bottom electrode contact overlapped with the cell region; forming an insulating structure to cover the bottom electrode contact; etching the insulating structure to form a buffer insulating layer overlapping the peripheral region and expose the bottom electrode contact; forming a bottom electrode layer to cover the bottom electrode contact and the buffer insulating layer; forming a magnetic tunnel junction layer on the bottom electrode layer; forming a preliminary top electrode on the magnetic tunnel junction layer; forming a top electrode, a magnetic tunnel junction pattern, and a bottom electrode by etching the preliminary top electrode, the magnetic tunnel junction layer, and the bottom electrode layer; and forming a capping insulating layer in contact with the top electrode and the buffer insulating layer.

At least some of the above and other features of the invention are set out in the claims.

### BRIEF DESCRIPTION OF THE DRAWINGS

FIG. 1 is a circuit diagram illustrating a unit memory cell of a semiconductor device, according to an embodiment of inventive concepts.
FIG. 2A is a plan view illustrating a semiconductor device according to an embodiment of inventive concepts.
FIG. 2B is a sectional view taken along a line A-A' of FIG. 2A.
FIG. 2C is an enlarged sectional view illustrating a portion 'B' of FIG. 2B.
FIGS. 3, 4, 5, 6, 7, 8, 9, 10, 11, 12, 13, 14, 15, 16, 17, 18, 19, and 20 are sectional views illustrating a method of fabricating the semiconductor device of FIGS. 2A, 2B, and 2C.
FIG. 21 is a sectional view illustrating a semiconductor device according to an embodiment of inventive concepts.
FIGS. 22, 23, and 24 are sectional views illustrating a method of fabricating the semiconductor device of FIG. 21.
FIG. 25 is a sectional view illustrating a semiconductor device according to an embodiment of inventive concepts.
FIG. 26 is an enlarged sectional view illustrating a semiconductor device according to an embodiment of inventive concepts.

### DETAILED DESCRIPTION

Example embodiments of inventive concepts will now be described more fully with reference to the accompanying drawings, in which example embodiments are shown.

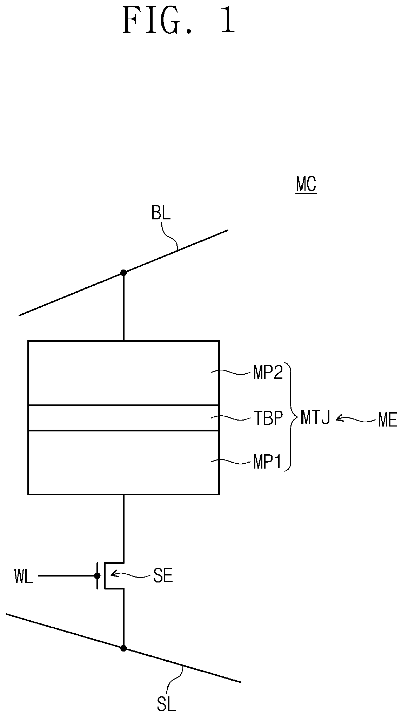

FIG. 1 is a circuit diagram illustrating a unit memory cell of a semiconductor device, according to an embodiment of inventive concepts.

Referring to FIG. 1, a unit memory cell MC may include a memory element ME and a selection element SE. The memory element ME and the selection element SE may be electrically connected to each other in series. The memory element ME may be provided between, and connected to, a bit line BL and the selection element SE. The selection element SE may be provided between, and connected to, the memory element ME and a source line SL and may be controlled by a word line WL. The selection element SE may include, for example, a bipolar transistor or a metal-oxide-semiconductor (MOS) field effect transistor.

The memory element ME may include a magnetic tunnel junction pattern MTJ including magnetic patterns MP1 and MP2, which are spaced apart from each other, and a tunnel barrier pattern TBP between the magnetic patterns MP1 and MP2. One of the magnetic patterns MP1 and MP2 may have a fixed magnetization direction, regardless of the presence of an external magnetic field generated under a typical user condition, and thus, it may serve as a reference magnetic pattern of the magnetic tunnel junction pattern MTJ. The other of the magnetic patterns MP1 and MP2 may have a magnetization direction, which can be changed to one of two stable magnetization directions by an external magnetic field, and thus, it may serve as a free magnetic pattern of the magnetic tunnel junction pattern MTJ. The electric resistance of the magnetic tunnel junction pattern MTJ may be much greater when the magnetization directions of the reference and free magnetic patterns are antiparallel to each other than when they are parallel to each other. The magnetization directions of the reference and free magnetic patterns may be antiparallel to each other when the angle between the magnetization directions of the reference and free magnetic patterns is 180°. The magnetization directions of the reference and free magnetic patterns may be parallel to each other when the angle between the magnetization directions of the reference and free magnetic patterns is 0°. This means that the electrical resistance of the magnetic tunnel junction pattern MTJ can be controlled by changing the magnetization direction of the free magnetic pattern. Thus, a difference in electric resistance of the magnetic tunnel junction pattern MTJ, which is caused by a difference in magnetization direction between the reference and free magnetic patterns, may be used to change data that is stored in the unit memory cell MC of the memory element ME.

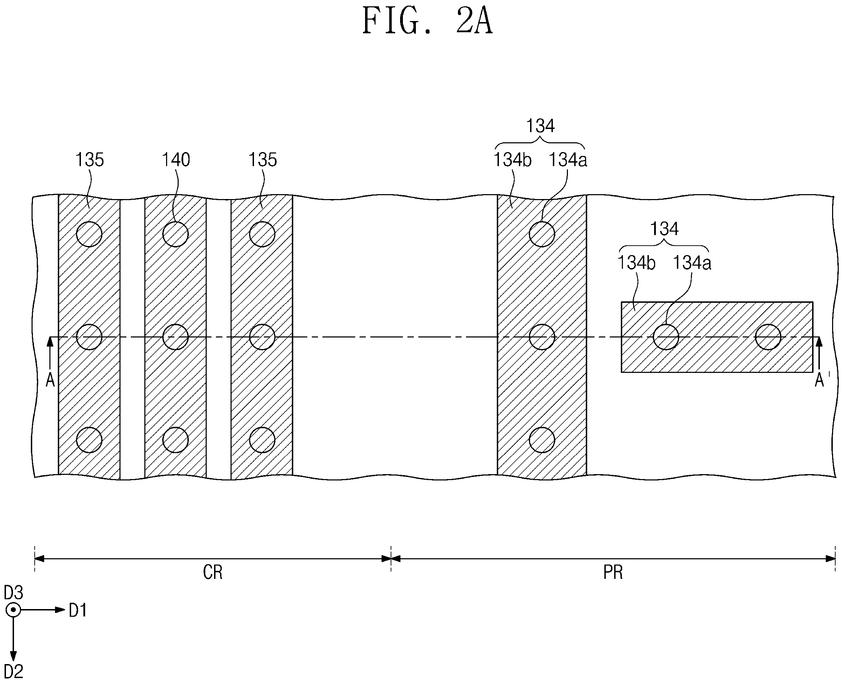

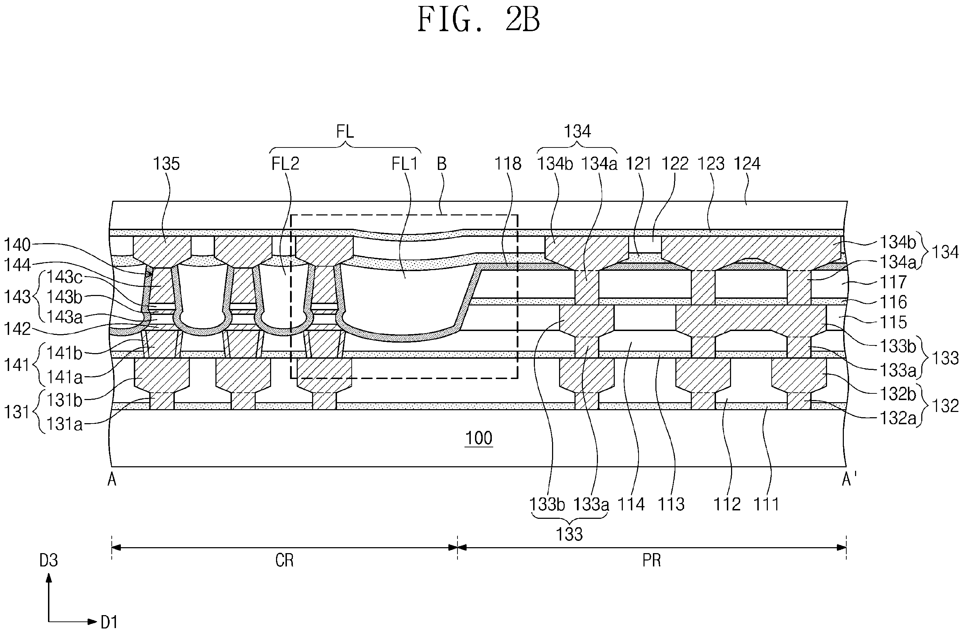

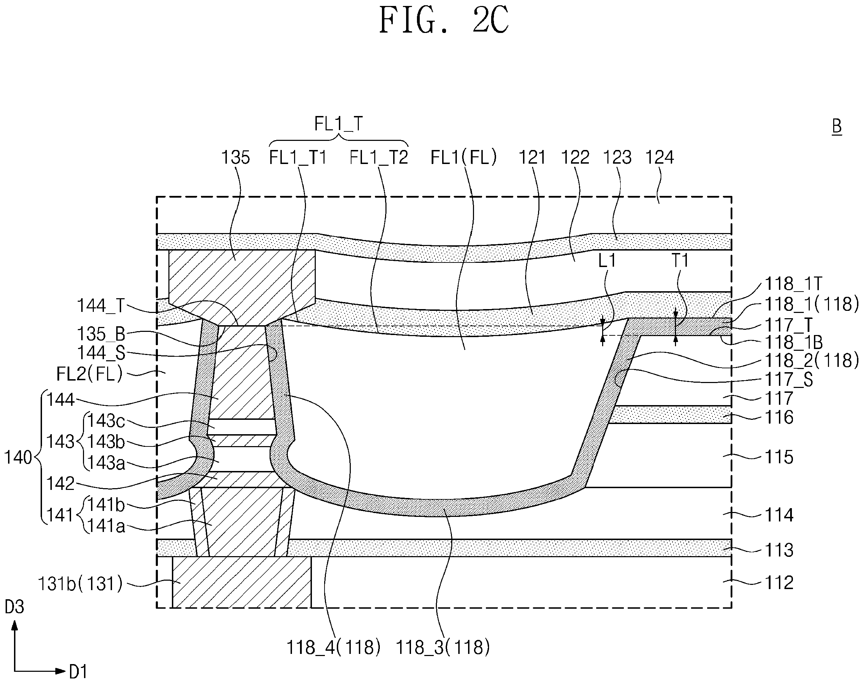

FIG. 2A is a plan view illustrating a semiconductor device according to an embodiment of inventive concepts. FIG. 2B is a sectional view taken along a line A-A' of FIG. 2A. FIG. 2C is an enlarged sectional view illustrating a portion 'B' of FIG. 2B.

Referring to FIGS. 2A and 2B, a semiconductor device may include a substrate 100. The substrate 100 may be a plate-shaped structure that extends parallel to a plane defined by a first direction D1 and a second direction D2. The first and second directions D1 and D2 may be non-parallel to each other (e.g. may intersect each other). In an embodiment, the first and second directions D1 and D2 may be two different horizontal directions, which are orthogonal to each other. In an embodiment, the substrate 100 may be a semiconductor substrate. As an example, the substrate 100 may be formed of or include silicon, germanium, silicon-germanium, GaP, or GaAs. In an embodiment, the substrate 100 may be a silicon-on-insulator (SOI) substrate or a germanium-on-insulator (GOI) substrate.

The substrate 100 may include a cell region CR and a peripheral region PR. The cell region CR and the peripheral region PR may be two distinct regions that are differentiated from each other in a plan view defined in the first and second directions D1 and D2.

The selection elements SE of FIG. 1 may be disposed on the substrate 100. As an example, the selection elements may be field effect transistors.

A first protection insulating layer 111 may be provided on the substrate 100. The first protection insulating layer 111 may be formed of or include one or more insulating materials. As an example, the first protection insulating layer 111 may be formed of or include silicon carbon nitride.

An interconnection insulating layer 112 may be provided on the first protection insulating layer 111. The interconnection insulating layer 112 may be formed of or include one or more low-k dielectric materials. A low-k dielectric material may be a material that has a dielectric constant that is less than that of silicon oxide (e.g. silicon dioxide). As an example, the interconnection insulating layer 112 may be formed of or include at least one of fluorine-doped silicon oxide, carbon-doped silicon oxide, or porous silicon oxide.

Cell conductive structures 131, which are overlapped with the cell region CR in a third direction D3, may be provided. The third direction D3 may be non-parallel to the first and second directions D1 and D2. As an example, the third direction D3 may be a vertical direction orthogonal to the first and second directions D1 and D2.

The cell conductive structure 131 may include a cell contact portion 131a and a cell line portion 131b on the cell contact portion 131a. The cell contact portion 131a may be provided to penetrate the first protection insulating layer 111. The cell contact portion 131a may be connected to the selection element on the substrate 100. The cell contact portion 131a may be enclosed by the first protection insulating layer 111 and the interconnection insulating layer 112. The cell line portion 131b may be extended in the second direction D2. The cell line portion 131b may be provided in the interconnection insulating layer 112. The cell contact portion 131a and the cell line portion 131b may be formed of or include one or more conductive materials.

The cell contact portion 131a and the cell line portion 131b may be connected to each other without an interface therebetween, and thus, the cell conductive structure 131 may have the structure of a single object. In an embodiment, there may be an interface between the cell contact portion 131a and the cell line portion 131b, and in this case, the cell conductive structure 131 may not have the structure of the single object.

First peripheral conductive structures 132, which are overlapped with the peripheral region PR in the third direction D3, may be provided. The first peripheral conductive structure 132 may include a first peripheral contact portion 132a and a first peripheral line portion 132b on the first peripheral contact portion 132a. The first peripheral contact portion 132a may be provided to penetrate the first protection insulating layer 111. The first peripheral contact portion 132a may be connected to the selection element on the substrate 100. The first peripheral contact portion 132a may be enclosed by the first protection insulating layer 111 and the interconnection insulating layer 112. The first peripheral line portion 132b may be extended in the second direction D2. The first peripheral line portion 132b may be provided in the interconnection insulating layer 112. The first peripheral contact portion 132a and the first peripheral line portion 132b may be formed of or include one or more conductive materials.

The first peripheral contact portion 132a and the first peripheral line portion 132b may be connected to each other without an interface therebetween, and thus, the first peripheral conductive structure 132 may have the structure of a single object. In an embodiment, there may be an interface between the first peripheral contact portion 132a and the first peripheral line portion 132b, and in this case, the first peripheral conductive structure 132 may not have the structure of the single object.

A second protection insulating layer 113 may be provided on the interconnection insulating layer 112, the cell conductive structure 131, and the first peripheral conductive structure 132. A bottom surface of the second protection insulating layer 113 may be in contact with a top surface of the cell line portion 131b of the cell conductive structure 131 and a top surface of the first peripheral line portion 132b of the first peripheral conductive structure 132. The second protection insulating layer 113 may be formed of or include one or more insulating materials. As an example, the second protection insulating layer 113 may be formed of or include silicon carbon nitride.

A lower insulating layer 114 may be provided on the second protection insulating layer 113. The lower insulating layer 114 may be formed of or include at least one low-k dielectric material. As an example, the lower insulating layer 114 may be formed of or include at least one of fluorine-doped silicon oxide, carbon-doped silicon oxide, or porous silicon oxide.

Data storage patterns 140, which are overlapped with the cell region CR in the third direction D3, may be provided. The data storage pattern 140 may include a bottom electrode contact 141, a bottom electrode 142, a magnetic tunnel junction pattern 143, and a top electrode 144.

The bottom electrode contacts 141 may be provided to penetrate the lower insulating layer 114 and the second protection insulating layer 113. The bottom electrode contact 141 may be provided on the cell line portion 131b of the cell conductive structure 131. The bottom electrode contact 141 may include a conductive layer 141a and a barrier layer 141b enclosing the conductive layer 141a. The conductive and barrier layers 141a and 141b of the bottom electrode contact 141 may be formed of or include different conductive materials from each other.

The bottom electrode 142 may be provided on the bottom electrode contact 141. The bottom electrode 142 may be formed of or include one or more conductive materials.

The magnetic tunnel junction pattern 143 may be provided on the bottom electrode 142. The magnetic tunnel junction pattern 143 may include a first magnetic pattern 143a on the bottom electrode 142, a tunnel barrier pattern 143b on the first magnetic pattern 143a, and a second magnetic pattern 143c on the tunnel barrier pattern 143b.

The first magnetic pattern 143a may be a reference layer having a fixed magnetization direction, and the second magnetic pattern 143c may be a free layer having a switchable magnetization direction. In an embodiment, the second magnetic pattern 143c may be a reference layer having a fixed magnetization direction, and the first magnetic pattern 143a may be a free layer having a switchable magnetization direction.

In an embodiment, the magnetization directions of the first and second magnetic patterns 143a and 143c may be perpendicular to an interface between the tunnel barrier pattern 143b and the second magnetic pattern 143c. In this case, each of the first and second magnetic patterns 143a and 143c may be formed of or include at least one of intrinsic or extrinsic perpendicular magnetic materials. An intrinsic perpendicular magnetic material may include a material exhibiting a perpendicular magnetization property, even when there is no external cause. An intrinsic perpendicular magnetic material may include at least one of i) perpendicular magnetic materials (e.g., CoFeTb, CoFeGd, and CoFeDy), ii) perpendicular magnetic materials with L1₀ structure, iii) CoPt-based materials with hexagonal-close-packed structure, or iv) perpendicular magnetic structures. The perpendicular magnetic materials with the L1₀ structure may include at least one of L1₀ FePt, L1₀ FePd, L1₀ CoPd, or L1₀ CoPt. The perpendicular magnetic structures may include magnetic and non-magnetic layers that are alternatingly and repeatedly stacked. For example, the perpendicular magnetic structure may include at least one of (Co/Pt)ₙ, (CoFe/Pt)ₙ, (CoFe/Pd)ₙ, (Co/Pd)ₙ, (Co/Ni)ₙ, (CoNi/Pt)ₙ, (CoCr/Pt)ₙ, or (CoCr/Pd)ₙ, where n is the number of stacked pairs of the layers. An extrinsic perpendicular magnetic material may include a material, which exhibits an intrinsic in-plane magnetization property when there is no external cause but exhibits a perpendicular magnetization property by an external cause. As an example, the extrinsic perpendicular magnetic material may have a perpendicular magnetization property, due to a magnetic anisotropy that is caused when the first or second magnetic pattern 143a or 143c is in contact with the tunnel barrier pattern 143b. The extrinsic perpendicular magnetic material may be formed of or include, for example, CoFeB.

In an embodiment, the magnetization directions of the first and second magnetic patterns 143a and 143c may be parallel to an interface between the tunnel barrier pattern 143b and the second magnetic pattern 143c. In this case, each of the first and second magnetic patterns 143a and 143c may be formed of or include at least one ferromagnetic material. The first magnetic pattern 143a may further include an antiferromagnetic material, which is used to fix the magnetization direction of the ferromagnetic material in the first magnetic pattern 143a.

In an embodiment, each of the first and second magnetic patterns 143a and 143c may be formed of or include at least one Co-based Heusler alloy.

The tunnel barrier pattern 143b may be formed of or include at least one of magnesium oxide, titanium oxide, aluminum oxide, magnesium-zinc oxide, or magnesium-boron oxide.

The top electrode 144 may be provided on the second magnetic pattern 143c of the magnetic tunnel junction pattern 143. The top electrode 144 may be formed of or include one or more conductive materials.

A molding insulating layer 115, which is overlapped with the peripheral region PR in the third direction D3, may be provided. The molding insulating layer 115 may be provided on the lower insulating layer 114. The molding insulating layer 115 may be formed of or include at least one low-k dielectric material. As an example, the molding insulating layer 115 may be formed of or include at least one of fluorine-doped silicon oxide, carbon-doped silicon oxide, or porous silicon oxide.

Second peripheral conductive structures 133, which are overlapped with the peripheral region PR in the third direction D3, may be provided. The second peripheral conductive structure 133 may include a second peripheral contact portion 133a and a second peripheral line portion 133b. The second peripheral contact portion 133a may be provided to penetrate the second protection insulating layer 113. The second peripheral contact portion 133a may be connected to the first peripheral line portion 132b of the first peripheral conductive structure 132. The second peripheral contact portion 133a may be enclosed by the second protection insulating layer 113 and the lower insulating layer 114. The second peripheral line portion 133b may be provided to penetrate the molding insulating layer 115. The second peripheral contact portion 133a and the second peripheral line portion 133b may be formed of or include one or more conductive materials.

At least one of the second peripheral conductive structures 133 may include the second peripheral line portion 133b, which extends in the second direction D2. The second peripheral line portion 133b, which extends in the second direction D2, may be electrically connected to one of the first peripheral conductive structures 132 through the second peripheral contact portions 133a, which are arranged in the second direction D2. At least one of the second peripheral conductive structures 133 may include the second peripheral line portion 133b, which extends in the first direction D1. The second peripheral line portion 133b, which extends in the first direction D1, may be electrically connected to a plurality of the first peripheral conductive structures 132 through the second peripheral contact portions 133a arranged in the first direction D1.

The second peripheral contact portion 133a and the second peripheral line portion 133b may be connected to each other without an interface therebetween, and thus, the second peripheral conductive structure 133 may have the structure of a single object. In an embodiment, there may be an interface between the second peripheral contact portion 133a and the second peripheral line portion 133b, and in this case, the second peripheral conductive structure 133 may not have the structure of the single object.

An intervening insulating layer 116, which is overlapped with the peripheral region PR in the third direction D3, may be provided. The intervening insulating layer 116 may be provided on the molding insulating layer 115. A bottom surface of the intervening insulating layer 116 may be in contact with a top surface of the second peripheral line portion 133b of the second peripheral conductive structure 133. The intervening insulating layer 116 may be formed of or include one or more insulating materials. As an example, the intervening insulating layer 116 may be formed of or include silicon carbon nitride.

A buffer insulating layer 117, which is overlapped with the peripheral region PR in the third direction D3, may be provided. The buffer insulating layer 117 may be provided on the intervening insulating layer 116. The intervening insulating layer 116 may be interposed between the molding insulating layer 115 and the buffer insulating layer 117. The buffer insulating layer 117 may be formed of or include one or more low-k dielectric materials. As an example, the buffer insulating layer 117 may be formed of or include at least one of fluorine-doped silicon oxide, carbon-doped silicon oxide, or porous silicon oxide.

A capping insulating layer 118 may be provided. The capping insulating layer 118 may be in contact with the buffer insulating layer 117, the intervening insulating layer 116, the molding insulating layer 115, the lower insulating layer 114, the bottom electrode 142, the magnetic tunnel junction pattern 143, and the top electrode 144. The capping insulating layer 118 may be formed of or include one or more insulating materials. As an example, the capping insulating layer 118 may be formed of or include silicon nitride.

A filling insulating layer FL may be provided on the capping insulating layer 118. The filling insulating layer FL may include a first filling insulating portion FL1, which is interposed between the buffer insulating layer 117 and the top electrode 144, and a second filling insulating portions FL2, which is interposed between the top electrodes 144. The filling insulating layer FL may be formed of or include one or more insulating materials. As an example, the filling insulating layer FL may be formed of or include silicon oxide.

A third protection insulating layer 121 may be provided on the capping insulating layer 118 and the filling insulating layer FL. The third protection insulating layer 121 may be formed of or include one or more insulating materials. As an example, the third protection insulating layer 121 may be formed of or include silicon carbon nitride.

An upper insulating layer 122 may be provided on the third protection insulating layer 121. The upper insulating layer 122 may be formed of or include one or more low-k dielectric materials. As an example, the upper insulating layer 122 may be formed of or include at least one of fluorine-doped silicon oxide, carbon-doped silicon oxide, or porous silicon oxide.

Cell conductive lines 135, which are overlapped with the cell region CR in the third direction D3, may be provided. The cell conductive line 135 may be provided on the top electrode 144 of the data storage pattern 140. The cell conductive line 135 may be extended in the second direction D2. The cell conductive line 135 may be connected to a plurality of the data storage patterns 140, which are arranged in the second direction D2. The cell conductive lines 135 may be arranged in the first direction D1. The cell conductive line 135 may be provided to penetrate the upper insulating layer 122 and the third protection insulating layer 121. The cell conductive line 135 may be formed of or include one or more conductive materials.

Third peripheral conductive structures 134, which are overlapped with the peripheral region PR in the third direction D3, may be provided. The third peripheral conductive structure 134 may include a third peripheral contact portion 134a and a third peripheral line portion 134b. The third peripheral contact portion 134a may be provided to penetrate the buffer insulating layer 117 and the intervening insulating layer 116. The third peripheral contact portion 134a may be connected to the second peripheral line portion 133b of the second peripheral conductive structure 133. The third peripheral contact portion 134a may be enclosed by the buffer insulating layer 117 and the intervening insulating layer 116. The third peripheral line portion 134b may be provided to penetrate the upper insulating layer 122 and the third protection insulating layer 121. The third peripheral contact portion 134a and the third peripheral line portion 134b may be formed of or include one or more conductive materials.

At least one of the third peripheral conductive structures 134 may include the third peripheral line portion 134b, which extends in the second direction D2, and third peripheral contact portions 134a, which are arranged in the second direction D2. At least one of the third peripheral conductive structures 134 may include the third peripheral line portion 134b, which extends in the first direction D1, and the third peripheral contact portions 134a, which are arranged in the first direction D1.

The third peripheral contact portion 134a and the third peripheral line portion 134b may be connected to each other without an interface therebetween, and thus, the third peripheral conductive structure 134 may have the structure of a single object. In an embodiment, there may be an interface between the third peripheral contact portion 134a and the third peripheral line portion 134b, and in this case, the third peripheral conductive structure 134 may not have the structure of the single object.

A fourth protection insulating layer 123 may be provided on the upper insulating layer 122, the cell conductive lines 135, and the third peripheral conductive structures 134. A bottom surface of the fourth protection insulating layer 123 may be in contact with a top surface of the cell conductive line 135 and a top surface of the third peripheral line portion 134b of the third peripheral conductive structure 134. The fourth protection insulating layer 123 may be formed of or include one or more insulating materials. As an example, the fourth protection insulating layer 123 may be formed of or include silicon carbon nitride.

A cover insulating layer 124 may be provided on the fourth protection insulating layer 123. The cover insulating layer 124 may be formed of or include one or more insulating materials.

The upper insulating layer 122, the buffer insulating layer 117, the molding insulating layer 115, the lower insulating layer 114, and the interconnection insulating layer 112 may be formed of or include an insulating material different from the capping insulating layer 118, the filling insulating layer FL, the first to fourth protection insulating layers 111, 113, 121, and 123, and the intervening insulating layer 116. The capping insulating layer 118 may be formed of or include an insulating material different from the filling insulating layer FL, the first to fourth protection insulating layers 111, 113, 121, and 123, and the intervening insulating layer 116. The filling insulating layer FL may be formed of or include an insulating material different from the first to fourth protection insulating layers 111, 113, 121, and 123, and the intervening insulating layer 116.

Dielectric constants of the upper insulating layer 122, the buffer insulating layer 117, the molding insulating layer 115, the lower insulating layer 114, the interconnection insulating layer 112, and the capping insulating layer 118 may be smaller than dielectric constants of the filling insulating layer FL, the first to fourth protection insulating layers 111, 113, 121, and 123, and the intervening insulating layer 116.

Referring to FIG. 2C, the capping insulating layer 118 may include a first portion 118_1 in contact with a top surface 117_T of the buffer insulating layer 117, a second portion 118_2 in contact with a side surface 117_S of the buffer insulating layer 117, a third portion 118_3 in contact with the lower insulating layer 114, and a fourth portion 118_4 in contact with a side surface 144_S of the top electrode 144.

The second portion 118_2 of the capping insulating layer 118 may be in contact with a side surface of the intervening insulating layer 116 and a side surface of the molding insulating layer 115. The fourth portion 118_4 of the capping insulating layer 118 may be in contact with a side surface of the magnetic tunnel junction pattern 143 and a side surface of the bottom electrode 142. The third portion 118_3 of the capping insulating layer 118 may be spaced apart from the second protection insulating layer 113 by the lower insulating layer 114.

A level of a top surface 144_T of the top electrode 144 may be higher than a level of the top surface 117_T of the buffer insulating layer 117. A distance L1 between the level of the top surface 144_T of the top electrode 144 and the level of the top surface 117_T of the buffer insulating layer 117 may be smaller than a thickness of the first portion 118_1 of the capping insulating layer 118. As an example, the distance L1 between the level of the top surface 144_T of the top electrode 144 and the level of the top surface 117_T of the buffer insulating layer 117 may be smaller than a thickness T1 of the first portion 118_1 of the capping insulating layer 118 in the third direction D3. The distance L1 between the top surface 144_T of the top electrode 144 and the top surface 117_T of the buffer insulating layer 117 may be smaller than the thickness of the first portion 118_1 of the capping insulating layer 118. As described herein, a "level" may represent a relative position along the third direction D3 (e.g. a distance from a top surface of the substrate 100). A level that is higher than another level may be located at a position further along the third direction D3 (e.g. further from the top surface of the substrate 100). Conversely, a level that is lower than another level may be located less far along the third direction D3 (e.g. closer to the top surface of the substrate 100).

The distance L1 between the level of the top surface 144_T of the top electrode 144 and the level of the top surface 117_T of the buffer insulating layer 117 may be smaller than thicknesses of the intervening insulating layer 116, the buffer insulating layer 117, the molding insulating layer 115, the lower insulating layer 114, the upper insulating layer 122, the first to fourth protection insulating layers 111, 113, 121, and 123, the interconnection insulating layer 112, and the cover insulating layer 124.

A level of a top surface 118_1T of the first portion 118_1 of the capping insulating layer 118 may be higher than the level of the top surface 144_T of the top electrode 144. A level of a bottom surface 118_1B of the first portion 118_1 of the capping insulating layer 118 may be lower than the level of the top surface 144_T of the top electrode 144.

A bottom surface 135_B of the cell conductive line 135 may be in contact with the top surface 144_T of the top electrode 144. A level of the bottom surface 135_B of the cell conductive line 135 may be higher than the level of the top surface 117_T of the buffer insulating layer 117. A level of the top surface 118_1T of the first portion 118_1 of the capping insulating layer 118 may be higher than the level of the bottom surface 135_B of the cell conductive line 135. A level of the bottom surface 118_1B of the first portion 118_1 of the capping insulating layer 118 may be lower than the level of the bottom surface 135_B of the cell conductive line 135.

A top surface FL1_T of the first filling insulating portion FL1 of the filling insulating layer FL may include a first portion FL1_T1, which is disposed at a level higher than the top surface 144_T of the top electrode 144, and a second portion FL1_T2, which is disposed at a level lower than the top surface 144_T of the top electrode 144.

The top surface FL1_T of the first filling insulating portion FL1 of the filling insulating layer FL may be in contact with a bottom surface of the third protection insulating layer 121. The first filling insulating portion FL1 of the filling insulating layer FL may be in contact with the second portion 118_2, the third portion 118_3, and the fourth portion 118_4 of the capping insulating layer 118.

The filling insulating layer FL may include a portion disposed at the same level as the buffer insulating layer 117, a portion disposed at the same level as the intervening insulating layer 116, and a portion disposed at the same level as the molding insulating layer 115. The filling insulating layer FL may include a portion disposed at the same level as the top electrode 144, a portion disposed at the same level as the magnetic tunnel junction pattern 143, and a portion disposed at the same level as the bottom electrode 142.

A thickness of the buffer insulating layer 117 may be larger than a thickness of the capping insulating layer 118. As an example, a thickness of the buffer insulating layer 117 in the third direction D3 may be larger than the thickness T1 of the first portion 118_1 of the capping insulating layer 118 in the third direction D3.

The side surface 117_S of the buffer insulating layer 117, the side surface of the intervening insulating layer 116, and the side surface of the molding insulating layer 115 may be inclined at an angle (e.g. relative to a top surface of the substrate 100). As an example, the side surface 117_S of the buffer insulating layer 117, the side surface of the intervening insulating layer 116, and the side surface of the molding insulating layer 115 may be inclined at an angle to a top surface of the substrate 100. The second portion 118_2 of the capping insulating layer 118 may be inclined at an angle corresponding to the side surface 117_S of the buffer insulating layer 117, the side surface of the intervening insulating layer 116, and the side surface of the molding insulating layer 115.

Since the semiconductor device includes the buffer insulating layer 117, a level difference between the cell region CR and the peripheral region PR may be reduced. Thus, it may be possible to limit or prevent or suppress a void from being formed in the filling insulating layer FL and improve the electrical characteristics of the semiconductor device.

Since the buffer insulating layer 117 and the molding insulating layer 115 include low-k dielectric materials, the electrical characteristics of the semiconductor device may be improved.

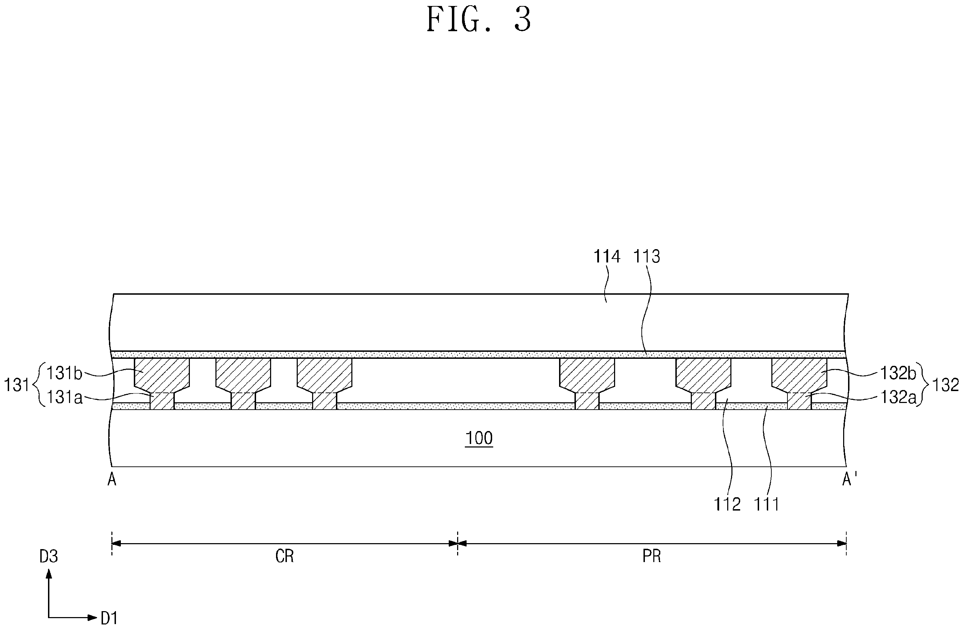

FIGS. 3, 4, 5, 6, 7, 8, 9, 10, 11, 12, 13, 14, 15, 16, 17, 18, 19, and 20 are sectional views illustrating a method of fabricating the semiconductor device of FIGS. 2A, 2B, and 2C.

Referring to FIG. 3, the substrate 100 including the cell region CR and the peripheral region PR may be provided. The first protection insulating layer 111 may be formed on the substrate 100. The interconnection insulating layer 112 may be formed on the first protection insulating layer 111. The cell conductive structures 131 and the first peripheral conductive structures 132 may be formed to penetrate the interconnection insulating layer 112 and the first protection insulating layer 111.

The second protection insulating layer 113 may be formed on the interconnection insulating layer 112. The lower insulating layer 114 may be formed on the second protection insulating layer 113.

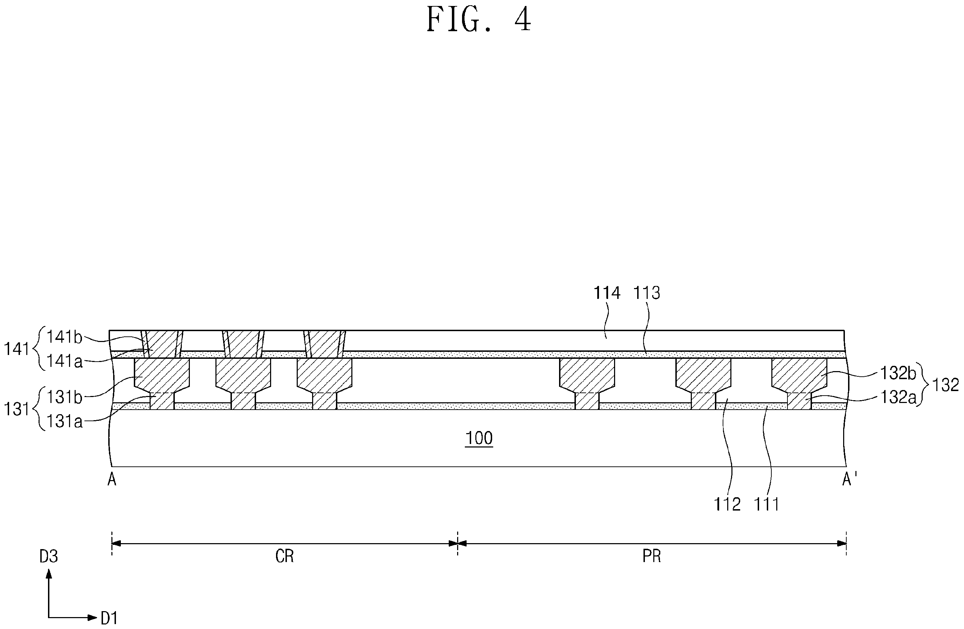

Referring to FIG. 4, the lower insulating layer 114 may be etched to remove an upper portion of the lower insulating layer 114. The bottom electrode contacts 141 may be formed to penetrate the lower insulating layer 114 and the second protection insulating layer 113.

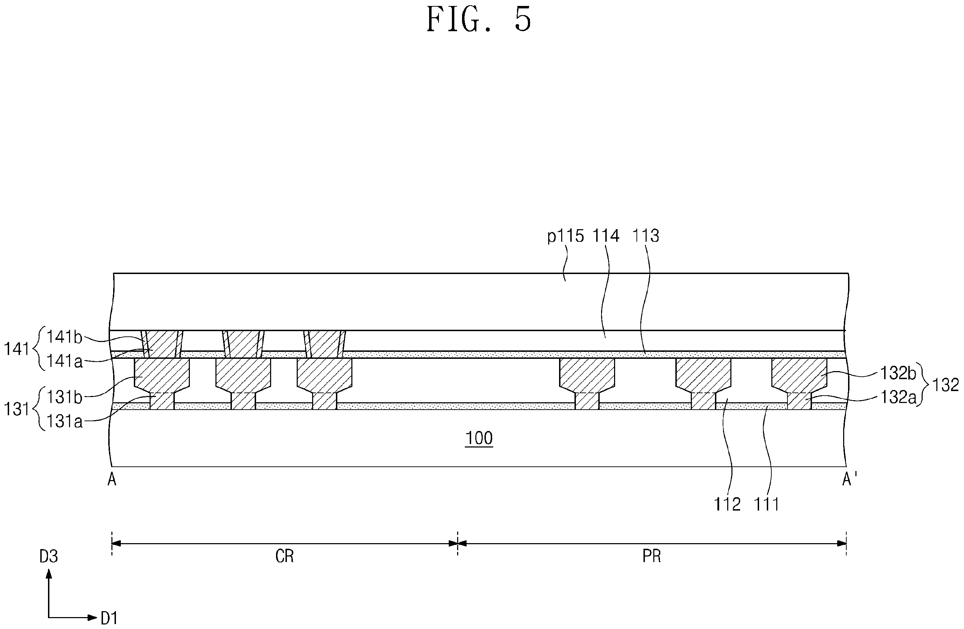

Referring to FIG. 5, a preliminary molding insulating layer p115 may be formed on the lower insulating layer 114. The preliminary molding insulating layer p115 may be formed of or include one or more low-k dielectric materials.

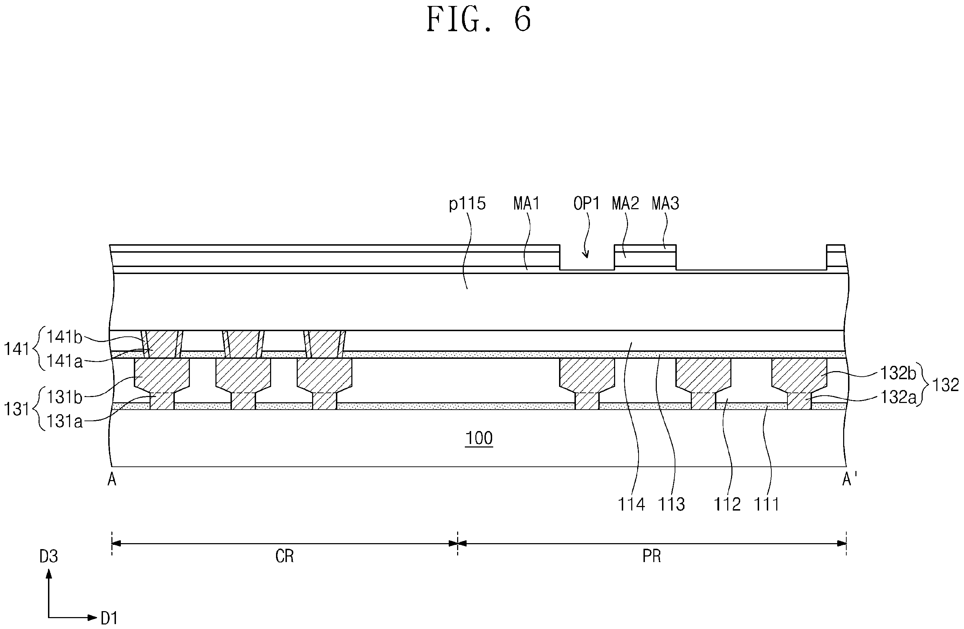

Referring to FIG. 6, a first mask layer MA1, a second mask layer MA2, and a third mask layer MA3 may be sequentially formed on the preliminary molding insulating layer p 115. The first to third mask layers MA1, MA2, and MA3 may be formed of or include one or more insulating materials.

First openings OP1 may be formed in the first to third mask layers MA1, MA2, and MA3.

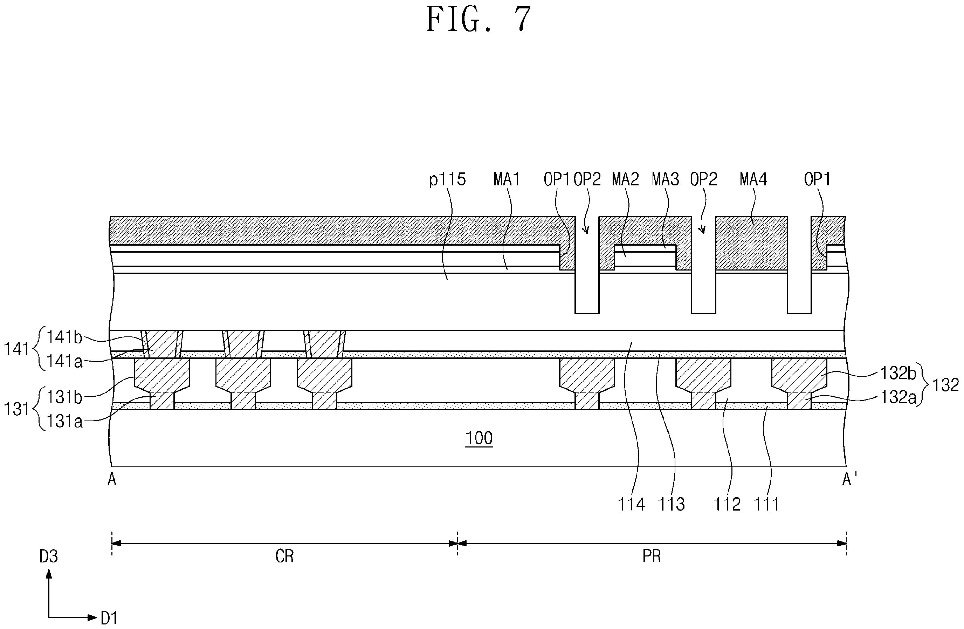

Referring to FIG. 7, a fourth mask layer MA4 may be formed on the first to third mask layers MA1, MA2, and MA3. The fourth mask layer MA4 may be formed of or include one or more insulating materials. The fourth mask layer MA4 may be formed to fill the first openings OP1. Second openings OP2 may be formed. The second opening OP2 may be overlapped with the first opening OP1 in the third direction D3. The preliminary molding insulating layer p115 may be exposed through the second opening OP2.

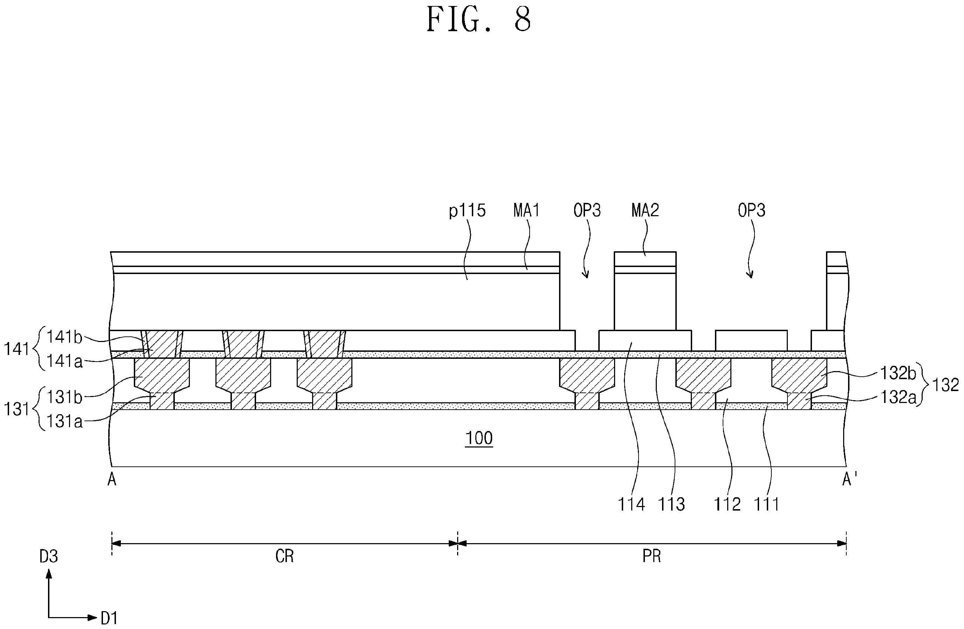

Referring to FIG. 8, third openings OP3 may be formed. The third opening OP3 may be formed as a result of a combination of the first and second openings OP1 and OP2. The fourth mask layer MA4 and the third mask layer MA3 may be removed during or after the process of forming the third opening OP3. The second protection insulating layer 113 and the lower insulating layer 114 may be exposed through the third opening OP3.

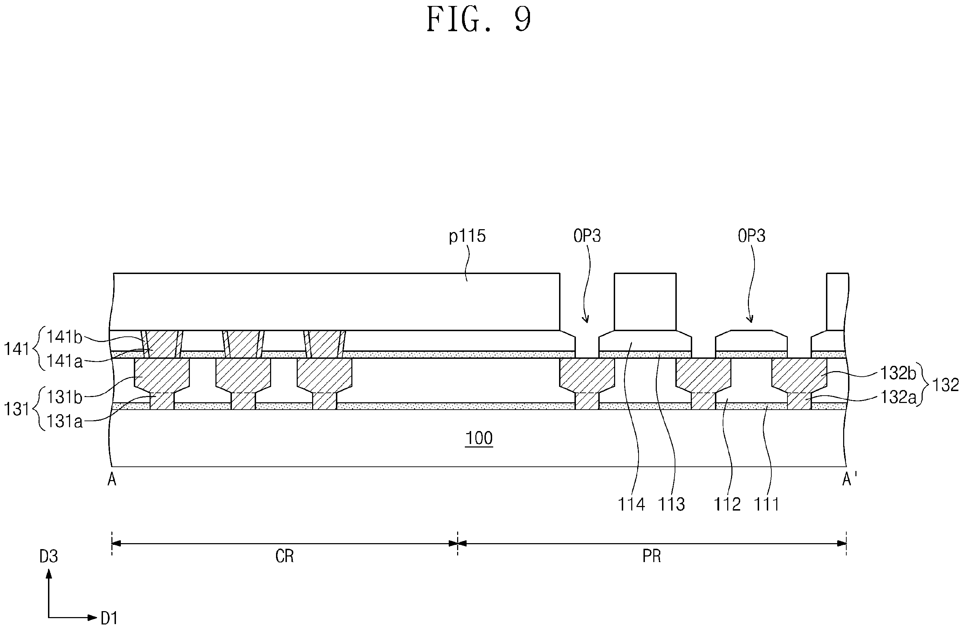

Referring to FIG. 9, the third opening OP3 may be enlarged. The second mask layer MA2 and the first mask layer MA1 may be removed during or after the process of enlarging the third opening OP3. The first peripheral conductive structure 132 may be exposed through the enlarged third opening OP3.

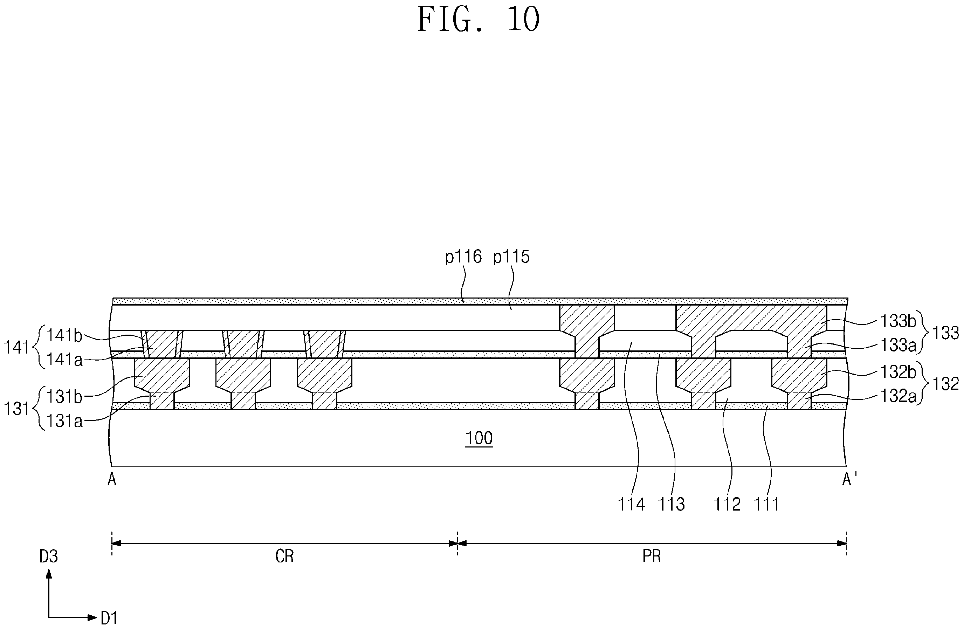

Referring to FIG. 10, the second peripheral conductive structures 133 may be formed. An upper portion of the preliminary molding insulating layer p115 may be removed through a chemical mechanical polishing process. A preliminary intervening insulating layer p116 may be formed on the preliminary molding insulating layer p115. The preliminary intervening insulating layer p116 may be formed of or include one or more insulating materials.

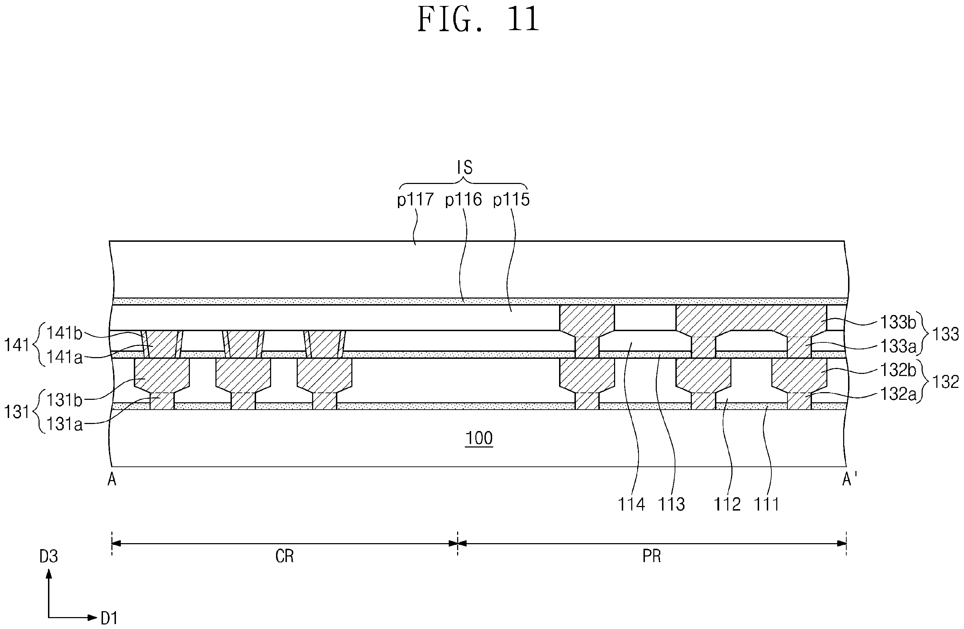

Referring to FIG. 11, a preliminary buffer insulating layer p117 may be formed on the preliminary intervening insulating layer p116. The preliminary buffer insulating layer p117 may be formed of or include one or more low-k dielectric materials. A structure including the preliminary buffer insulating layer p117, the preliminary intervening insulating layer p116, and the preliminary molding insulating layer p115 may be defined as an insulating structure IS. The insulating structure IS may cover the second peripheral conductive structures 133 and the bottom electrode contacts 141.

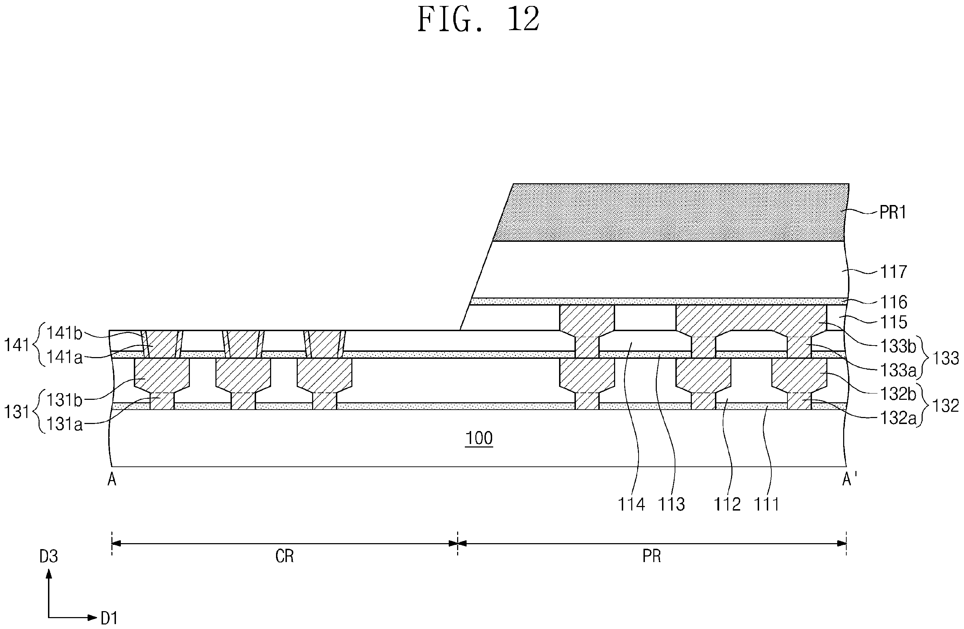

Referring to FIG. 12, the insulating structure IS may be etched. The etching of the insulating structure IS may include forming a photoresist pattern PR1 on the preliminary buffer insulating layer p117 and etching the preliminary buffer insulating layer p117, the preliminary intervening insulating layer p116, and the preliminary molding insulating layer p115 using the photoresist pattern PR1 as an etch mask. The preliminary buffer insulating layer p117 may be etched to form the buffer insulating layer 117. The preliminary intervening insulating layer p116 may be etched to form the intervening insulating layer 116. The preliminary molding insulating layer p115 may be etched to form the molding insulating layer 115.

As a result of the etching of the insulating structure IS, top surfaces of the bottom electrode contacts 141 may be exposed to the outside.

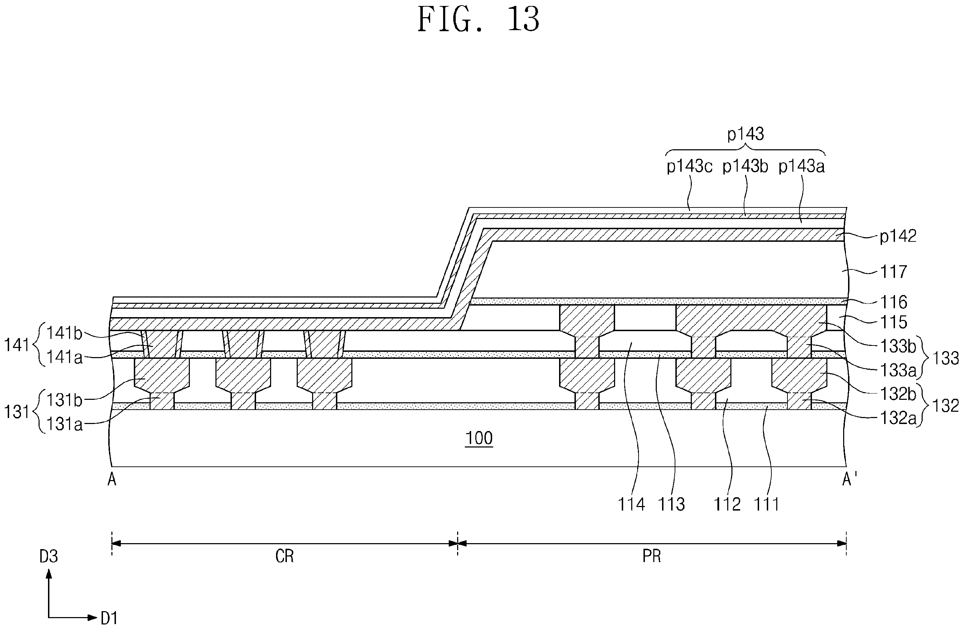

Referring to FIG. 13, a bottom electrode layer p142 may be formed. The bottom electrode layer p142 may be in contact with the bottom electrode contacts 141, the lower insulating layer 114, the molding insulating layer 115, the intervening insulating layer 116, and the buffer insulating layer 117. The bottom electrode layer p142 may be formed of or include a conductive material.

A magnetic tunnel junction layer p143 may be formed on the bottom electrode layer p142. The magnetic tunnel junction layer p143 may include a first magnetic layer p143a on the bottom electrode layer p142, a tunnel barrier layer p143b on the first magnetic layer p143a, and a second magnetic layer p143c on the tunnel barrier layer p143b.

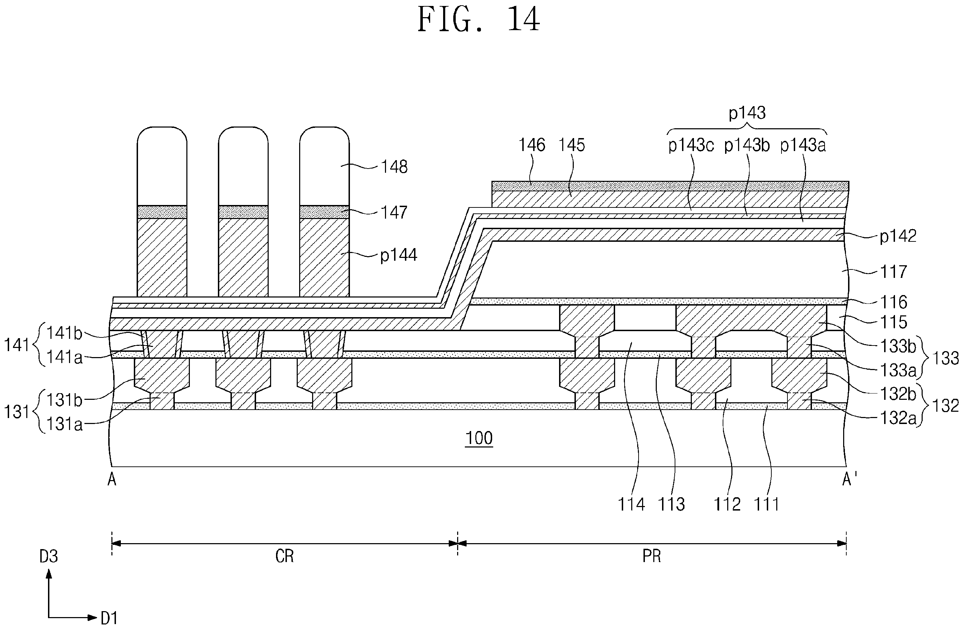

Referring to FIG. 14, preliminary top electrodes p144, first mask patterns 147, and second mask patterns 148 may be formed to be overlapped with the cell region CR in the third direction D3. A dummy conductive layer 145 and a dummy insulating layer 146 may be formed to be overlapped with the peripheral region PR in the third direction D3. The preliminary top electrodes p144 and the dummy conductive layer 145 may be formed of or include one or more conductive materials. The dummy insulating layer 146, the first mask patterns 147, and the second mask patterns 148 may be formed of or include one or more insulating materials.

The preliminary top electrodes p144 may be formed by an etching process using the first and second mask patterns 147 and 148 as an etch mask. The dummy conductive layer 145 and the dummy insulating layer 146 may be formed during the process of forming the preliminary top electrodes p144.

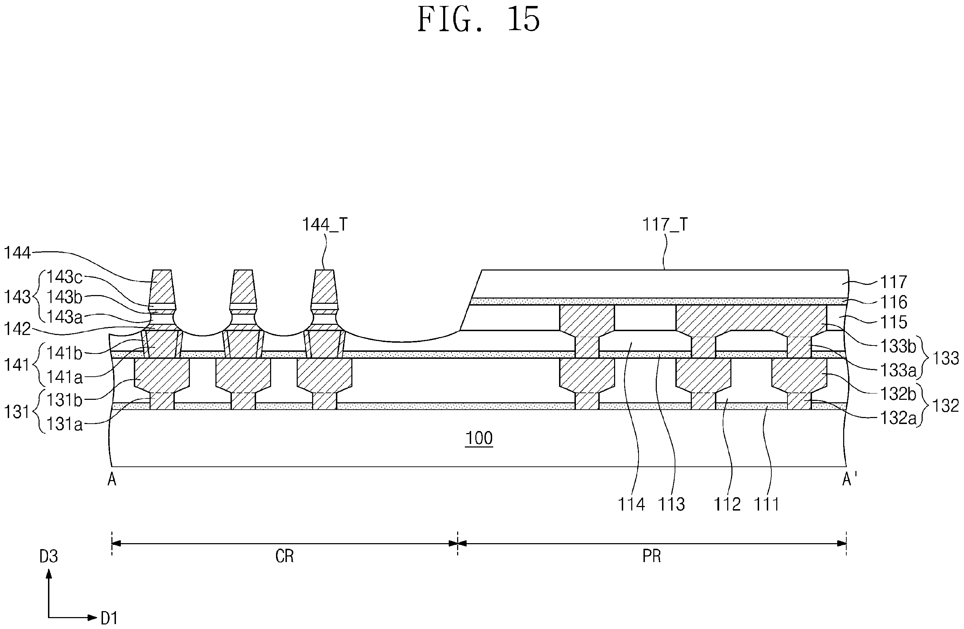

Referring to FIG. 15, an etching process may be performed using the preliminary top electrodes p144 as an etch mask. The first and second mask patterns 147 and 148, the dummy conductive layer 145, and the dummy insulating layer 146 may be removed before or during the etching process using the preliminary top electrodes p144 as the etch mask.

The preliminary top electrodes p144, the magnetic tunnel junction layer p143, the bottom electrode layer p142, the buffer insulating layer 117, and the lower insulating layer 114 may be etched by the etching process using the preliminary top electrodes p144 as the etch mask. The preliminary top electrodes p144 may be etched to form the top electrodes 144. The magnetic tunnel junction layer p143 may be etched to form the magnetic tunnel junction patterns 143. The bottom electrode layer p142 may be etched to form the bottom electrodes 142. An upper portion of the buffer insulating layer 117 may be removed by the etching process on the buffer insulating layer 117. The level of the top surface 1 17_T of the etched buffer insulating layer 117 may be lower than the level of the top surface 144_T of the top electrode 144.

In an embodiment, the level of the top surface 117_T of the etched buffer insulating layer 117 may be higher than the level of the top surface 144_T of the top electrode 144. In an embodiment, the level of the top surface 117_T of the etched buffer insulating layer 117 may be equal to the level of the top surface 144_T of the top electrode 144.

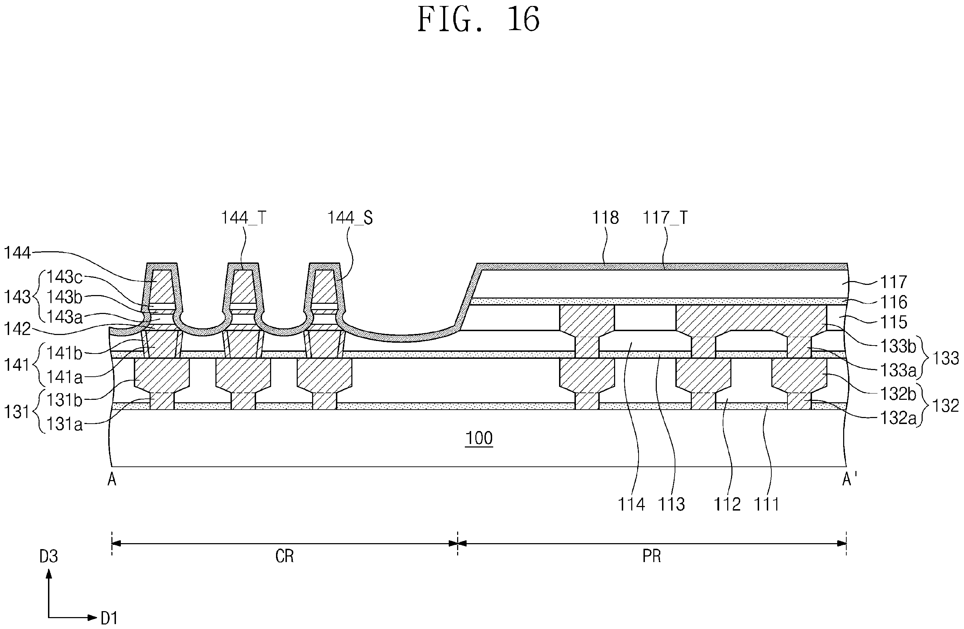

Referring to FIG. 16, the capping insulating layer 118 may be formed. The capping insulating layer 118 may be in contact with the top surface 117_T of the buffer insulating layer 117, the side surface 144_S and the top surface 144_T of the top electrode 144, the magnetic tunnel junction pattern 143, the bottom electrode 142, the lower insulating layer 114, the molding insulating layer 115, and the intervening insulating layer 116.

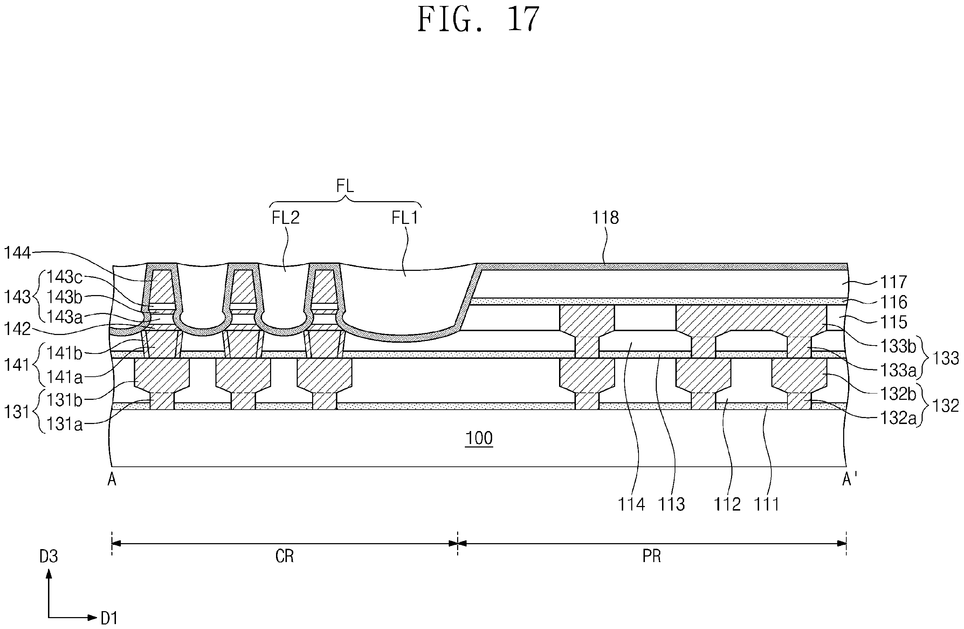

Referring to FIG. 17, the filling insulating layer FL may be formed on the capping insulating layer 118. In an embodiment, the filling insulating layer FL may be formed using an atomic layer deposition (ALD) process. In an embodiment, the filling insulating layer FL may be formed using a hybrid process including an ALD process and a high density plasma (HDP) process. Since the ALD process capable of limiting and/or preventing the formation of void is used, the first filling insulating portion FL1 may be formed to fill a space between the buffer insulating layer 117 and the top electrode 144 without any void, and the second filling insulating portion FL2 may be formed to fill a space between the top electrodes 144 without any void.

The filling insulating layer FL may be formed to expose a portion of the capping insulating layer 118.

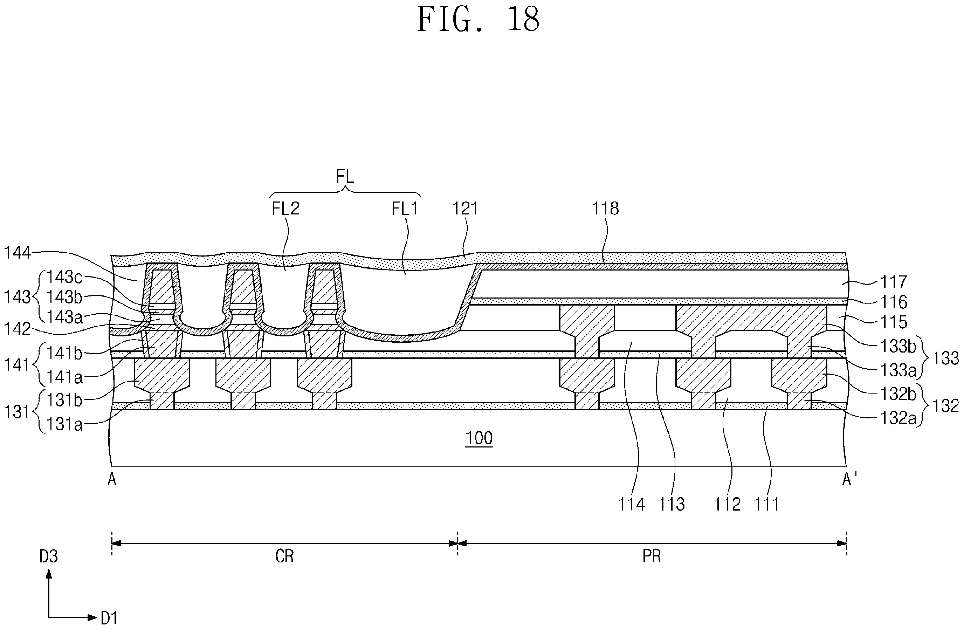

Referring to FIG. 18, the third protection insulating layer 121 may be formed on the capping insulating layer 118 and the filling insulating layer FL.

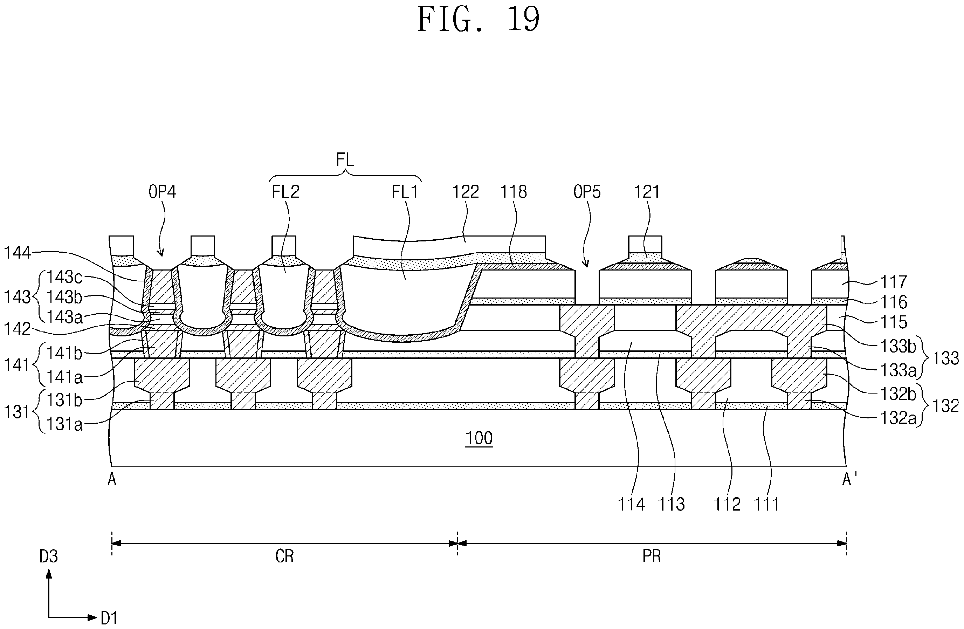

Referring to FIG. 19, the upper insulating layer 122 may be formed on the third protection insulating layer 121. Fourth openings OP4 may be formed to penetrate the upper insulating layer 122 and the third protection insulating layer 121. The fourth openings OP4 may be overlapped with the cell region CR in the third direction D3. The third protection insulating layer 121, the capping insulating layer 118, and the top electrode 144 may be exposed through the fourth opening OP4. Fifth openings OP5 may be formed to penetrate the upper insulating layer 122 and the third protection insulating layer 121. The fifth openings OP5 may be overlapped with the peripheral region PR in the third direction D3. The second peripheral line portion 133b of the second peripheral conductive structure 133, the intervening insulating layer 116, the buffer insulating layer 117, the capping insulating layer 118, and the third protection insulating layer 121 may be exposed through the fifth opening OP5.

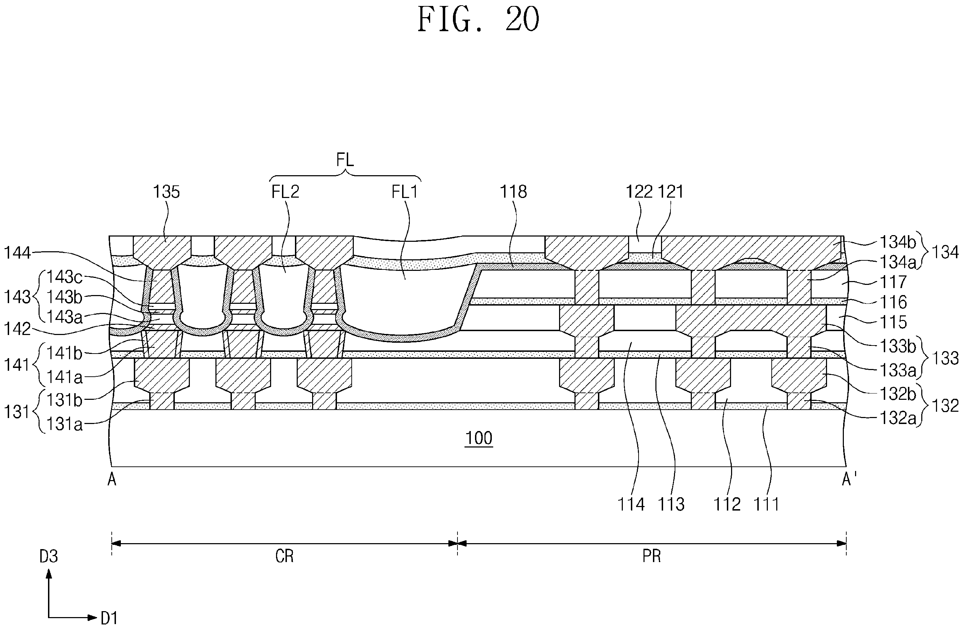

Referring to FIG. 20, the cell conductive line 135 may be formed in the fourth opening OP4. The third peripheral conductive structure 134 may be formed in the fifth opening OP5.

Referring back to FIG. 2B, the fourth protection insulating layer 123 may be formed on the upper insulating layer 122. The cover insulating layer 124 may be formed on the fourth protection insulating layer 123.

In the fabrication method according to an embodiment of inventive concepts, the buffer insulating layer 117 may be formed to have a sufficiently large thickness, and in this case, it may be possible to reduce and/or minimize a level difference between the top surface 117_T of the buffer insulating layer 117 and the top surface 144_T of the top electrode 144, after an etching process of forming the top electrode 144. Since the level difference between the top surface 117_T of the buffer insulating layer 117 and the top surface 144_T of the top electrode 144 is reduced and/or minimized, it may be possible to compensate a level difference, which is caused by the ALD process performed to form the filling insulating layer FL. Since the ALD process is used to form the filling insulating layer FL, it may be possible to limit or prevent or suppress a void from being formed in the filling insulating layer FL.

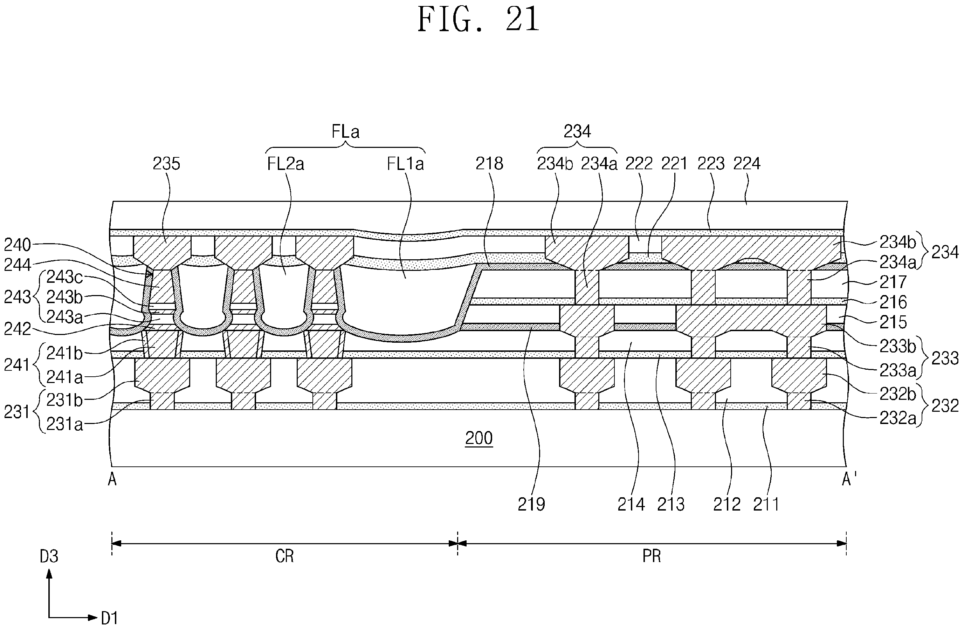

FIG. 21 is a sectional view illustrating a semiconductor device according to an embodiment of inventive concepts.

Referring to FIG. 21, a semiconductor device may include a substrate 200, first to fourth protection insulating layers 211, 213, 221, and 223, an interconnection insulating layer 212, first to third peripheral conductive structures 232, 233, and 234, cell conductive structures 231, data storage patterns 240, a lower insulating layer 214, an etch stop layer 219, a molding insulating layer 215, an intervening insulating layer 216, a buffer insulating layer 217, a capping insulating layer 218, a filling insulating layer FLa, an upper insulating layer 222, a cover insulating layer 224, and upper conductive lines 235.

The cell conductive structure 231 may include a cell contact portion 231a and a cell line portion 23 1b. Each of the first to third peripheral conductive structures 232, 233, and 234 may include a peripheral contact portion 232a, 233a, or 234a and a peripheral line portion 232b, 233b, or 234b. The data storage pattern 240 may include a bottom electrode contact 241, a bottom electrode 242, a magnetic tunnel junction pattern 243, and a top electrode 244. The bottom electrode contact 241 may include a conductive layer 241a and a barrier layer 241b. The magnetic tunnel junction pattern 243 may include a first magnetic pattern 243a, a tunnel barrier pattern 243b, and a second magnetic pattern 243c. The filling insulating layer Fla may include a first filling insulating portion FL1a and a second filling insulating portion FL2a.

The etch stop layer 219 may be overlapped with the peripheral region RP in the third direction D3. The etch stop layer 219 may be interposed between the lower insulating layer 214 and the molding insulating layer 215. The etch stop layer 219 may be in contact with the lower insulating layer 214, the capping insulating layer 218, and the molding insulating layer 215. The etch stop layer 219 may be in contact with the second peripheral conductive structure 233. The etch stop layer 219 may be formed of or include the same insulating material as the capping insulating layer 218. As an example, the etch stop layer 219 may be formed of or include silicon nitride.

The etch stop layer 219 may be formed of or include an insulating material that is different from the first to fourth protection insulating layers 211, 213, 221, and 223, the interconnection insulating layer 212, the lower insulating layer 214, the molding insulating layer 215, the intervening insulating layer 216, the buffer insulating layer 217, the filling insulating layer FLa, the upper insulating layer 222, and the cover insulating layer 224. A dielectric constant of the etch stop layer 219 may be smaller than dielectric constants of the first to fourth protection insulating layers 211, 213, 221, and 223, the intervening insulating layer 216, and the filling insulating layer FLa.

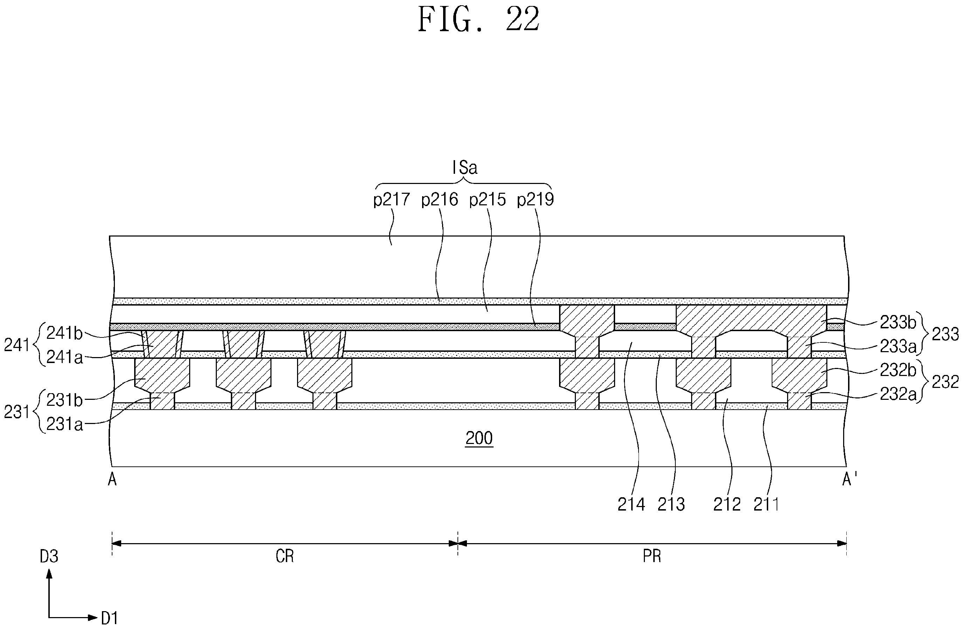

FIGS. 22, 23, and 24 are sectional views illustrating a method of fabricating the semiconductor device of FIG. 21.

Referring to FIG. 22, the substrate 200, the first protection insulating layer 211, the interconnection insulating layer 212, the cell conductive structures 231, the first peripheral conductive structures 232, the second protection insulating layer 213, the lower insulating layer 214, and the bottom electrode contacts 241 may be formed in a manner that is similar to those in the embodiment of FIG. 3 and 4.

A preliminary etch stop layer p219 may be formed on the bottom electrode contacts 241 and the lower insulating layer 214. A preliminary molding insulating layer p215 may be formed on the preliminary etch stop layer p219. The second peripheral conductive structures 233 may be formed to penetrate the preliminary etch stop layer p219, the preliminary molding insulating layer p215, and the second protection insulating layer 213.

A preliminary intervening insulating layer p216 may be formed on the preliminary molding insulating layer p215. A preliminary buffer insulating layer p217 may be formed on the preliminary intervening insulating layer p216. A structure including the preliminary buffer insulating layer p217, the preliminary intervening insulating layer p216, the preliminary molding insulating layer p215, and the preliminary etch stop layer p219 may be defined as an insulating structure ISa. The insulating structure ISa may cover the bottom electrode contacts 241.

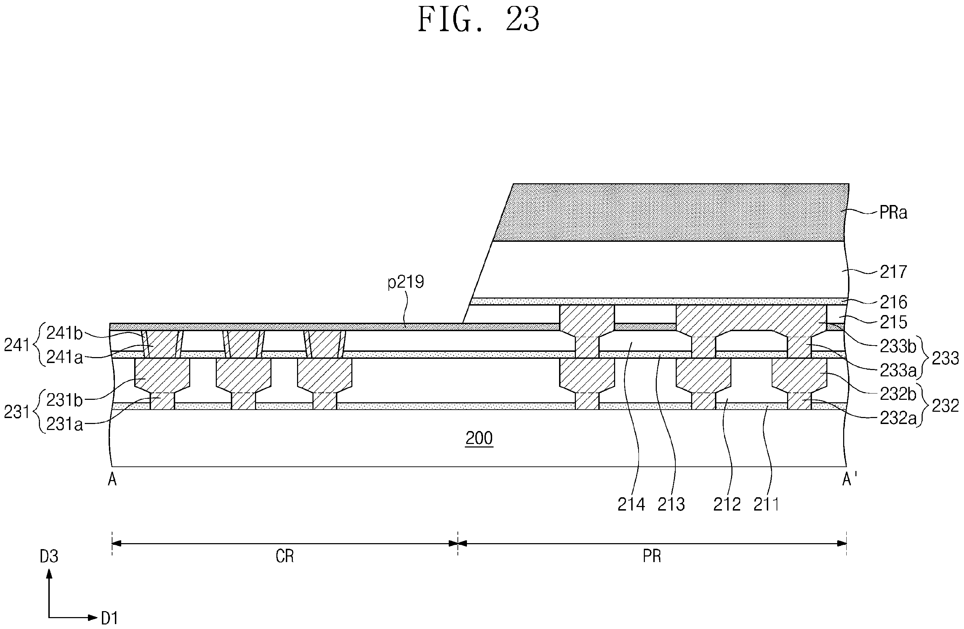

Referring to FIG. 23, the preliminary buffer insulating layer p217, the preliminary intervening insulating layer p216, and the preliminary molding insulating layer p215 may be etched. The etching of the preliminary buffer insulating layer p217, the preliminary intervening insulating layer p216, and the preliminary molding insulating layer p215 may include forming a photoresist pattern PRa on the preliminary buffer insulating layer p217 and etching the preliminary buffer insulating layer p217, the preliminary intervening insulating layer p216, and the preliminary molding insulating layer p215 using the photoresist pattern PRa as an etch mask.

In the process of etching the preliminary buffer insulating layer p217, the preliminary intervening insulating layer p216, and the preliminary molding insulating layer p215, a portion of the preliminary etch stop layer p219, which is overlapped with the cell region CR in the third direction D3, may be left. The portion of the preliminary etch stop layer p219, which is overlapped with the cell region CR in the third direction D3, may be exposed to the outside through the process of etching the preliminary buffer insulating layer p217, the preliminary intervening insulating layer p216, and the preliminary molding insulating layer p215.

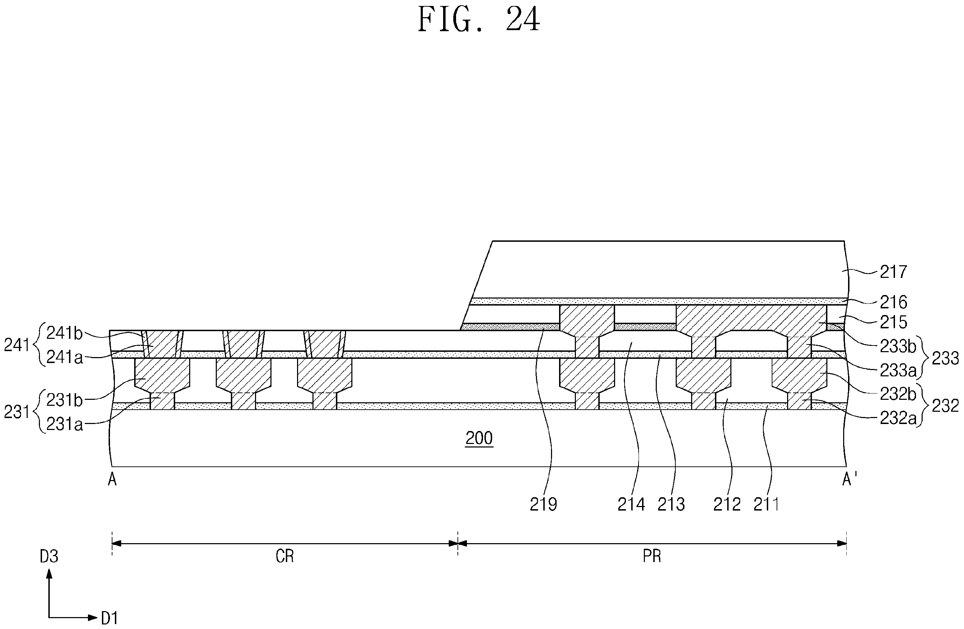

Referring to FIG. 24, the etch stop layer 219 may be formed by selectively etching the preliminary etch stop layer p219. As an example, the preliminary etch stop layer p219 may be selectively etched by an etch-back process. Since the preliminary etch stop layer p219 is selectively etched, the portion of the preliminary etch stop layer p219, which is overlapped with the cell region CR in the third direction D3, may be removed. The bottom electrode contacts 241 may be exposed to the outside, as a result of the removal of the portion of the preliminary etch stop layer p219 overlapped with the cell region CR in the third direction D3.

Referring to FIG. 21, the remaining elements of the semiconductor device may be formed through a method that is similar to that in the previous embodiment described with reference to FIG. 13 to 20.

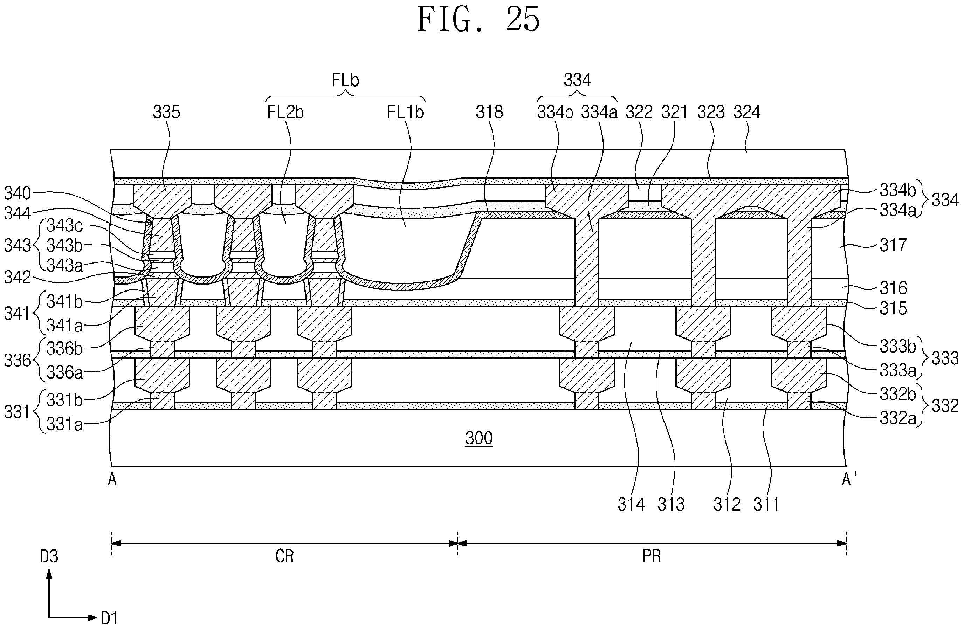

FIG. 25 is a sectional view illustrating a semiconductor device according to an embodiment of inventive concepts.

Referring to FIG. 25, a semiconductor device may include a substrate 300, first to fifth protection insulating layers 311, 313, 315, 321, and 323, a first interconnection insulating layer 312, a second interconnection insulating layer 314, first to third peripheral conductive structures 332, 333, and 334, first and second cell conductive structures 331 and 336, data storage patterns 340, a lower insulating layer 316, a buffer insulating layer 317, a capping insulating layer 318, a filling insulating layer FLb, an upper insulating layer 322, cover insulating layer 324, and upper conductive lines 335.

Each of the first and second cell conductive structures 331 and 336 may include a cell contact portion 331a or 336a and a cell line portion 331b or 336b. Each of the first to third peripheral conductive structures 332, 333, and 334 may include a peripheral contact portion 332a, 333a, or 334a and a peripheral line portion 332b, 333b, or 334b. The data storage pattern 340 may include a bottom electrode contact 341, a bottom electrode 342, a magnetic tunnel junction pattern 343, and a top electrode 344. The bottom electrode contact 341 may include a conductive layer 341a and a barrier layer 341b. The magnetic tunnel junction pattern 343 may include a first magnetic pattern 343a, a tunnel barrier pattern 343b, and a second magnetic pattern 343c. The filling insulating layer FLb may include a first filling insulating portion FL1b and a second filling insulating portion FL2b.

The first cell conductive structures 331 and the first peripheral conductive structures 332 may be provided to penetrate the first protection insulating layer 311 and the first interconnection insulating layer 312. The second cell conductive structures 336 and the second peripheral conductive structures 333 may be provided to penetrate the second protection insulating layer 313 and the second interconnection insulating layer 314.

A bottom surface of the third protection insulating layer 315 may be in contact with top surfaces of the second cell conductive structures 336 and the second peripheral conductive structures 333. The lower insulating layer 316 may be provided on the third protection insulating layer 315. The buffer insulating layer 317 may be provided on the lower insulating layer 316. The peripheral contact portion 334a of the third peripheral conductive structure 334 may be provided to penetrate the buffer insulating layer 317, the lower insulating layer 316, and the third protection insulating layer 315.

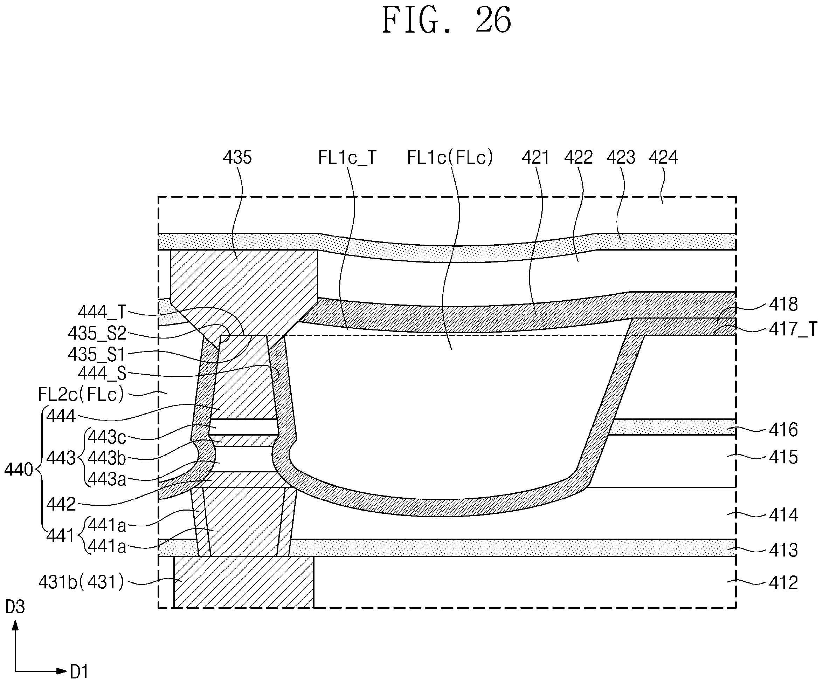

FIG. 26 is an enlarged sectional view illustrating a semiconductor device according to an embodiment of inventive concepts.

Referring to FIG. 26, a semiconductor device may include first to third protection insulating layers 413, 421, and 423, an interconnection insulating layer 412, a cell conductive structure 431, a data storage pattern 440, a lower insulating layer 414, a molding insulating layer 415, an intervening insulating layer 416, a buffer insulating layer 417, a capping insulating layer 418, a filling insulating layer FLc, an upper insulating layer 422, a cover insulating layer 424, and an upper conductive line 435.

The cell conductive structure 431 may include a cell line portion 431b. The data storage pattern 440 may include a bottom electrode contact 441, a bottom electrode 442, a magnetic tunnel junction pattern 443, and a top electrode 444. The bottom electrode contact 441 may include a conductive layer 441a and a barrier layer 441b. The magnetic tunnel junction pattern 443 may include a first magnetic pattern 443a, a tunnel barrier pattern 443b, and a second magnetic pattern 443c. The filling insulating layer FLc may include a first filling insulating portion FL1c and a second filling insulating portion FL2c.

A level of a top surface 417_T of the buffer insulating layer 417 may be equal to a level of a top surface 444_T of the top electrode 444. A top surface FL1c_T of the first filling insulating portion FL1c of the filling insulating layer FLc may be disposed at a level higher than the top surface 444_T of the top electrode 444 and the top surface 417_T of the buffer insulating layer 417.

The upper conductive line 435 may include a first surface 435_S1, which is in contact with the top surface 444_T of the top electrode 444, and a second surface 435_S2, which is in contact with a side surface 444_S of the top electrode 444.

According to an embodiment of inventive concepts, since a semiconductor device includes a buffer insulating layer, it may be possible to reduce a level difference between a cell region and a peripheral region and limit or prevent or suppress a void from being formed in a filling insulating layer.

In a method of fabricating a semiconductor device according to an embodiment of inventive concepts, it may be possible to compensate a level difference, which is caused by an ALD process, and to limit or prevent or suppress a void from being formed in in the filling insulating layer.

While example embodiments of inventive concepts have been particularly shown and described, it will be understood by one of ordinary skill in the art that variations in form and detail may be made therein without departing from the scope of the attached claims.

## Claims

1. A semiconductor device, comprising:
a substrate including a cell region and a peripheral region;
a bottom electrode overlapping the cell region;
a magnetic tunnel junction pattern on the bottom electrode;
a top electrode on the magnetic tunnel junction pattern;
a buffer insulating layer overlapping the peripheral region;
a capping insulating layer in contact with a side surface of the top electrode and a top surface of the buffer insulating layer; and
a first peripheral conductive structure penetrating the capping insulating layer and the buffer insulating layer, wherein
a level difference between the top surface of the buffer insulating layer and a top surface of the top electrode is smaller than a thickness of the capping insulating layer.

2. The semiconductor device of claim 1, further comprising:
a filling insulating layer on the capping insulating layer, wherein
the filling insulating layer comprises a filling insulating portion between the top electrode and the buffer insulating layer, and
a dielectric constant of the buffer insulating layer is smaller than a dielectric constant of the filling insulating layer.

3. The semiconductor device of claim 2, wherein
a top surface of the filling insulating portion comprises a first portion and a second portion,
the first portion of the filling insulating portion is disposed at a level higher than the top surface of the top electrode, and
the second portion of the filling insulating portion is disposed at a level lower than the top surface of the top electrode.

4. The semiconductor device of any preceding claim, further comprising:
a bottom electrode contact connected to the bottom electrode;
a lower insulating layer enclosing the bottom electrode contact; and
a molding insulating layer between the lower insulating layer and the buffer insulating layer.

5. The semiconductor device of claim 4, wherein
the capping insulating layer comprises a first portion and a second portion,
the first portion of the capping insulating layer is in contact with the top surface of the buffer insulating layer, and
the second portion of the capping insulating layer is in contact with a side surface of the buffer insulating layer and a side surface of the molding insulating layer.

6. The semiconductor device of claim 4 or claim 5, further comprising:
an intervening insulating layer between the molding insulating layer and the buffer insulating layer, wherein
a dielectric constant of the intervening insulating layer is higher than a dielectric constant of the buffer insulating layer and a dielectric constant of the molding insulating layer.

7. The semiconductor device of claim 6, wherein
the first peripheral conductive structure comprises a first peripheral contact portion and a first peripheral line portion on the first peripheral contact portion, and
the first peripheral contact portion penetrates the intervening insulating layer.

8. The semiconductor device of claim 7, further comprising:
a second peripheral conductive structure penetrating the lower insulating layer and the molding insulating layer, wherein
the second peripheral conductive structure comprises a second peripheral contact portion and a second peripheral line portion on the second peripheral contact portion, and
a bottom surface of the intervening insulating layer is in contact with a top surface of the second peripheral line portion.

9. The semiconductor device of any preceding claim, further comprising:
a protection insulating layer on the capping insulating layer, wherein
a dielectric constant of the capping insulating layer is smaller than a dielectric constant of the protection insulating layer.

10. The semiconductor device of claim 9, wherein the first peripheral conductive structure penetrates the protection insulating layer.

11. A method of fabricating a semiconductor device, comprising:
providing a substrate including a cell region and a peripheral region;
forming a bottom electrode contact overlapping the cell region;
forming an insulating structure covering the bottom electrode contact;
etching the insulating structure to form a buffer insulating layer overlapping the peripheral region and expose the bottom electrode contact;
forming a bottom electrode layer covering the bottom electrode contact and the buffer insulating layer;
forming a magnetic tunnel junction layer on the bottom electrode layer;
forming a preliminary top electrode on the magnetic tunnel junction layer;
forming a top electrode, a magnetic tunnel junction pattern, and a bottom electrode by etching the preliminary top electrode, the magnetic tunnel junction layer, and the bottom electrode layer; and
forming a capping insulating layer in contact with the top electrode and the buffer insulating layer.

12. The method of claim 11, further comprising:
forming a filling insulating layer on the capping insulating layer.

13. The method of claim 12, wherein a dielectric constant of the filling insulating layer is higher than a dielectric constant of the buffer insulating layer.

14. The method of claim 12 or claim 13, wherein the filling insulating layer exposes a portion of the capping insulating layer.

15. The method of any of claims 12-14, wherein the forming the filling insulating layer is performed using an atomic layer deposition process.
